# EUROPEAN PATENT APPLICATION

(11) **EP 4 832 720 A1**
(43) Date of publication of application: **28.10.2026**
(21) Application number: 24959035.7
(22) Date of filing: 31.10.2024
(51) Int. Cl.: H10K 59/35

(54) **DISPLAY PANEL AND PREPARATION METHOD THEREFOR, AND DISPLAY APPARATUS**

(71) Applicant: BOE Technology Group Co., Ltd., Beijing 100015 (CN); Chengdu BOE Optoelectronics Technology Co., Ltd., Chengdu, Sichuan 611731 (CN)
(72) Inventor: ZHANG, Hongbin, Beijing 100176 (CN); CHEN, Wenbin, Beijing 100176 (CN); WANG, Xinye, Beijing 100176 (CN); LAI, Tianqi, Beijing 100176 (CN)
(74) Representative: Hoffmann Eitle
(86) International application number: PCT/CN2024/129096
(87) International publication number: WO 2026/091026

(57) **Abstract**

A display panel and a preparation method therefor, and a display apparatus. The display panel (10) comprises a substrate (1), a first conductive layer (21), a first planarization layer (51), a first electrode layer (4), and a support portion (8). The first conductive layer is located on one side of the substrate. The first planarization layer is located on the side of the first conductive layer away from the substrate, and the first planarization layer is provided with a first through hole (511). The first electrode layer is located on the side of the first planarization layer away from the substrate, the first electrode layer comprises a first electrode (41) of a light-emitting device (F), and the first electrode located in a secondary display region (A2) is electrically connected to the first conductive layer by means of the first through hole. The support portion is located in the secondary display area, the first planarization layer covers the support portion, the support portion is disposed close to the first through hole, and the support portion is located on the side of the first through hole close to the center of the first electrode. The material of the support portion is different from the material of the first planarization layer. The described display panel is used to display an image.

## Description

### TECHNICAL FIELD

The present disclosure relates to the field of display technologies, and in particular, to a display panel and a manufacturing method therefor, and a display apparatus.

### BACKGROUND

With the continuous development of display technologies, display apparatuses have gradually become ubiquitous in people's lives. Organic light-emitting diode (OLED) display panels are widely used in display apparatuses such as mobile phones, televisions and notebook computers due to self-luminescence, low power consumption, wide viewing angle, fast response speed, high contrast, and other advantages.

### SUMMARY

In an aspect, a display panel is provided. The display panel includes a main display area and a secondary display area, and the main display area surrounds at least a part of the secondary display area. The display panel includes light-emitting devices of at least one color located in the main display area and the secondary display area; an effective light-emitting area of a light-emitting device, located in the main display area, of the light-emitting devices of at least one color is greater than an effective light-emitting area of a light-emitting device, located in the secondary display area and having a same color as the light-emitting device located in the main display area, of the light-emitting devices of at least one color.

The display panel further includes a substrate, a first conductive layer, a first planarization layer, a first electrode layer, and support portions. The first conductive layer is located on a side of the substrate. The first planarization layer is located on a side of the first conductive layer away from the substrate, and the first planarization layer has first through holes. The first electrode layer is located on a side of the first planarization layer away from the substrate. The first electrode layer includes first electrodes of the light-emitting devices of at least one color, and a first electrode in light-emitting devices of at least one color located in the secondary display area is electrically connected to the first conductive layer through a first through hole. The support portions are located in the secondary display area, and the first planarization layer covers the support portions; a support portion is close to the first through hole, and is located on a side of the first through hole close to a center of the first electrode. A material of the support portion is different from a material of the first planarization layer.

In some embodiments, the support portion is embedded in the first planarization layer; in a thickness direction of the display panel, there is a gap between the support portion and the first conductive layer, and between the support portion and the first electrode.

In some embodiments, the support portion is in contact with the first conductive layer.

In some embodiments, the material of the support portion is same as a material of the first conductive layer, and the support portion and the first conductive layer are in an integral structure.

In some embodiments, the material of the support portion includes at least one of metal and metal oxide.

In some embodiments, the support portion surrounds at least a portion of the first through hole.

In some embodiments, the first through hole has a first opening located in a surface of the first planarization layer away from the substrate, and a second opening located in a surface of the first planarization layer close to the substrate. An area of the first opening is greater than an area of the second opening. In orthographic projections on the substrate, at least a portion of the support portion is located between boundaries of the first opening and the second opening.

In some embodiments, the display panel further includes a pixel definition layer located on a side of the first electrode layer away from the substrate, and the pixel definition layer has pixel openings. The first through hole has a first opening located in a surface of the first planarization layer away from the substrate, and a second opening located in a surface of the first planarization layer close to the substrate; an area of the first opening is greater than an area of the second opening. In orthographic projections on the substrate, at least a portion of the support portion is located between boundaries of the second opening and a pixel opening.

In some embodiments, a straight line passing through a center of the first through hole and along a preset direction is a reference line, and the preset direction is a direction in which a main body portion and a connection portion of the first electrode are connected. A boundary of the first through hole intersects the reference line at a first intersection point and a second intersection point, and the first intersection point is farther away from the pixel opening than the second intersection point. A boundary of the pixel opening intersects the reference line at a third intersection point and a fourth intersection point, and the third intersection point is closer to the first through hole than the fourth intersection point. A distance between the second intersection point and the third intersection point is a first length, and a distance between the third intersection point and the fourth intersection point is a second length.

The light-emitting devices of at least one color include first color light-emitting devices, and a second length corresponding to a first color light-emitting device is less than a second length corresponding to other color light-emitting devices. The support portions include a first support portion, and the first support portion is close to a first through hole corresponding to a first electrode of the first color light-emitting device.

In some embodiments, the light-emitting devices of at least one color further include second color light-emitting devices. The support portions further include a second support portion, and the second support portion is close to a first through hole corresponding to a first electrode of a second color light-emitting device. The second length corresponding to the first color light-emitting device is less than a second length corresponding to the second color light-emitting device. A dimension of the first support portion along an axis of the preset direction is greater than a dimension of the second support portion along the axis of the preset direction.

In some embodiments, the first length is L1, and the second length is L2. L1 is greater than or equal to 7 µm; or L1 is less than 7 µm, and L2 = n × L1 + m, where -1.5 ≥ n ≥ -3 and 30 ≥ m ≥ 20.

In some embodiments, light-emitting devices of at least one color located in the secondary display area are arranged in an array along a row direction and a column direction. Along the column direction, first through holes corresponding to first electrodes in two adjacent rows of first color light-emitting devices are located between pixel openings corresponding to the first electrodes in the two adjacent rows of first color light-emitting devices; or along the row direction, first through holes corresponding to first electrodes in two adjacent columns of first color light-emitting devices are located between pixel openings corresponding to the first electrodes in the two adjacent columns of first color light-emitting devices.

In some embodiments, the light-emitting devices of at least one color further include second color light-emitting devices. Along the column direction, first through holes corresponding to first electrodes in two adjacent rows of second color light-emitting devices are located between pixel openings corresponding to the first electrodes in the two adjacent rows of second color light-emitting devices; or along the row direction, first through holes corresponding to first electrodes in two adjacent columns of second color light-emitting devices are located between pixel openings corresponding to the first electrodes in the two adjacent columns of second color light-emitting devices.

In some embodiments, inner diameters of the pixel opening along different axial directions are not completely equal, and the pixel opening has a maximum inner diameter value along an axis of a preset direction. The preset direction is a direction in which a main body portion and a connection portion of the first electrode are connected.

In some embodiments, at least two first electrodes located in the secondary display area are electrically connected to the first conductive layer through a same first through hole.

In some embodiments, two first electrodes are electrically connected to the first conductive layer through the same first through hole, and the two first electrodes are located on opposite sides of the first through hole.

In some embodiments, the support portion is arranged around the first through hole; or there are two support portions, and the two support portions are located on opposite sides of the first through hole.

In some embodiments, the display panel further includes a second conductive layer, a second planarization layer, first pixel circuits, and second pixel circuits. The second conductive layer is located on a side of the first conductive layer close to the substrate. The second planarization layer is located between the second conductive layer and the first conductive layer. The first pixel circuits are located in the main display area; light-emitting devices of at least one color located in the main display area are electrically connected to corresponding first pixel circuits, and the light-emitting devices of at least one color located in the main display area overlap with the corresponding first pixel circuits in a thickness direction of the display panel.

The second pixel circuits are located in the main display area; light-emitting devices of at least one color located in the secondary display area are electrically connected to corresponding second pixel circuits at least through conductive lines of the first conductive layer and/or conductive lines of the second conductive layer; the light-emitting devices of at least one color located in the secondary display area have non-overlapping with the corresponding second pixel circuits in the thickness direction of the display panel. Alternatively, the second pixel circuits are located in the secondary display area; the light-emitting devices of at least one color located in the secondary display area are electrically connected to corresponding second pixel circuits at least through conductive portions of the first conductive layer and/or conductive portions of the second conductive layer; the light-emitting devices of at least one color located in the secondary display area overlap with the corresponding second pixel circuits in the thickness direction of the display panel.

In another aspect, a display panel is provided. The display panel includes a main display area and a secondary display area, and the main display area surrounds at least a part of the secondary display area. The display panel includes light-emitting devices of at least one color located in the main display area and the secondary display area; an effective light-emitting area of a light-emitting device, located in the main display area, of the light-emitting devices of at least one color is greater than an effective light-emitting area of a light-emitting device, located in the secondary display area and having a same color as the light-emitting device located in the main display area, of the light-emitting devices of at least one color.

The display panel includes a substrate, a first conductive layer, a first planarization layer, a first electrode layer, and a pixel definition layer. The first conductive layer is located on a side of the substrate. The first planarization layer is located on a side of the first conductive layer away from the substrate, and the first planarization layer has first through holes. The first electrode layer is located on a side of the first planarization layer away from the substrate. The first electrode layer includes first electrodes of the light-emitting devices of at least one color, and a first electrode in light-emitting devices of at least one color located in the secondary display area is electrically connected to the first conductive layer through a first through hole. The pixel definition layer is located on a side of the first electrode layer away from the substrate, and the pixel definition layer has pixel openings. The first electrode includes a main body portion and a connection portion, and the main body portion overlaps with a pixel opening in a thickness direction of the display panel; the connection portion is electrically connected to the main body portion, and the connection portion passes through the first through hole and is electrically connected to the first conductive layer.

A straight line passing through a center of the first through hole and along a preset direction is a reference line, and the preset direction is a direction in which the main body portion and the connection portion of the first electrode are connected. A boundary of the first through hole intersects the reference line at a first intersection point and a second intersection point, and the first intersection point is farther away from the pixel opening than the second intersection point. A boundary of the pixel opening intersects the reference line at a third intersection point and a fourth intersection point, and the third intersection point is closer to the first through hole than the fourth intersection point. A distance between the second intersection point and the third intersection point is a first length, and a distance between the third intersection point and the fourth intersection point is a second length. The first length is L1, and the second length is L2. L1 is greater than or equal to 7 µm; or L1 is less than 7 µm, and L2 = n × L1 + m, where -1.5 ≥ n ≥ -3 and 30 ≥ m ≥ 20.

In yet another aspect, a display panel is provided. The display panel includes a main display area and a secondary display area, and the main display area surrounds at least a part of the secondary display area. The display panel includes light-emitting devices of at least one color located in the main display area and the secondary display area; an effective light-emitting area of a light-emitting device, located in the main display area, of the light-emitting devices of at least one color is greater than an effective light-emitting area of a light-emitting device, located in the secondary display area and having a same color as the light-emitting device located in the main display area, of the light-emitting devices of at least one color.

The display panel includes a substrate, a first conductive layer, a first planarization layer, a first electrode layer, and a pixel definition layer. The first conductive layer is located on a side of the substrate. The first planarization layer is located on a side of the first conductive layer away from the substrate, and the first planarization layer has first through holes. The first electrode layer is located on a side of the first planarization layer away from the substrate. The first electrode layer includes first electrodes of the light-emitting devices of at least one color, and a first electrode in light-emitting devices of at least one color located in the secondary display area is electrically connected to the first conductive layer through a first through hole. The first electrode includes a main body portion and a connection portion electrically connected to the main body portion, and the connection portion passes through the first through hole and is electrically connected to the first conductive layer. The pixel definition layer is located on a side of the first electrode layer away from the substrate. The pixel definition layer has pixel openings; the main body portion overlaps with a pixel opening in a thickness direction of the display panel. Inner diameters of the pixel opening along different axial directions are not completely equal, and the pixel opening has a maximum inner diameter value along an axis of a preset direction. The preset direction is a direction in which the main body portion and the connection portion of the first electrode are connected.

In yet another aspect, a display panel is provided. The display panel includes a main display area and a secondary display area, and the main display area surrounds at least a part of the secondary display area. The display panel includes light-emitting devices of at least one color located in the main display area and the secondary display area; an effective light-emitting area of a light-emitting device, located in the main display area, of the light-emitting devices of at least one color is greater than an effective light-emitting area of a light-emitting device, located in the secondary display area and having a same color as the light-emitting device located in the main display area, of the light-emitting devices of at least one color.

The display panel further includes a substrate, a first conductive layer, a first planarization layer, and a first electrode layer. The first conductive layer is located on a side of the substrate. The first planarization layer is located on a side of the first conductive layer away from the substrate, and the first planarization layer has first through holes. The first electrode layer is located on a side of the first planarization layer away from the substrate. The first electrode layer includes first electrodes of the light-emitting devices of at least one color; first electrodes of at least two light-emitting devices of at least one color located in the secondary display area are electrically connected to the first conductive layer through a same first through hole.

In yet another aspect, a display panel is provided. The display panel includes a main display area and a secondary display area, and the main display area surrounds at least a part of the secondary display area. The display panel includes light-emitting devices of at least one color located in the main display area and the secondary display area; an effective light-emitting area of a light-emitting device, located in the main display area, of the light-emitting devices of at least one color is greater than an effective light-emitting area of a light-emitting device, located in the secondary display area and having a same color as the light-emitting device located in the main display area, of the light-emitting devices of at least one color.

The display panel further includes a substrate, a first conductive layer, a first planarization layer, a first electrode layer, and a pixel definition layer. The first conductive layer is located on a side of the substrate. The first planarization layer is located on a side of the first conductive layer away from the substrate, and the first planarization layer has first through holes. The first electrode layer is located on a side of the first planarization layer away from the substrate. The first electrode layer includes first electrodes of the light-emitting devices of at least one color, and a first electrode in light-emitting devices of at least one color located in the secondary display area is electrically connected to the first conductive layer through a first through hole. The pixel definition layer is located on a side of the first electrode layer away from the substrate; the pixel definition layer has pixel openings, and the first electrode overlaps with a pixel opening in a thickness direction of the display panel.

Light-emitting devices of at least one color located in the secondary display area are arranged in an array along a row direction and a column direction. The light-emitting devices of at least one color include first color light-emitting devices. Along the column direction, first through holes corresponding to first electrodes in two adjacent rows of first color light-emitting devices are located between pixel openings corresponding to the first electrodes in the two adjacent rows of first color light-emitting devices; or along the row direction, first through holes corresponding to first electrodes in two adjacent columns of first color light-emitting devices are located between pixel openings corresponding to the first electrodes in the two adjacent columns of first color light-emitting devices.

In another aspect, a manufacturing method for a display panel is provided. The display panel includes a main display area and a secondary display area, and the main display area surrounds at least a part of the secondary display area. The display panel includes light-emitting devices of at least one color located in the main display area and the secondary display area; an effective light-emitting area of a light-emitting device, located in the main display area, of the light-emitting devices of at least one color is greater than an effective light-emitting area of a light-emitting device, located in the secondary display area and having a same color as the light-emitting device located in the main display area, of the light-emitting devices of at least one color.

The manufacturing method for the display panel, includes:
forming a first conductive layer on a side of a substrate;
forming a first planarization layer on a side of the first conductive layer away from the substrate, where within regions of the first planarization layer where first through holes are to be formed, a surface of the first planarization layer away from the substrate protrudes towards a side of the first planarization layer away from the substrate;
forming the first through holes in the first planarization layer; and
forming a first electrode layer on the side of the first planarization layer away from the substrate, where the first electrode layer includes first electrodes of the light-emitting devices of at least one color, and a first electrode in light-emitting devices of at least one color located in the secondary display area is electrically connected to the first conductive layer through a first through hole.

In yet another aspect, a display apparatus is provided. The display apparatus includes the display panel according to any one of the above embodiments and an optical device. The optical device is located on a non-display surface of the display panel and overlaps with the secondary display area of the display panel in a thickness direction of the display panel.

### BRIEF DESCRIPTION OF THE DRAWINGS

In order to describe technical solutions in the present disclosure more clearly, the accompanying drawings to be used in some embodiments of the present disclosure will be introduced briefly. Obviously, the accompanying drawings to be described below are merely drawings of some embodiments of the present disclosure, and a person of ordinary skill in the art can obtain other accompanying drawings according to those drawings. In addition, the accompanying drawings in the following description may be regarded as schematic diagrams, but are not limitations on actual sizes of products, actual processes of methods and actual timings of signals involved in the embodiments of the present disclosure.
FIG. 1 is a structural diagram of a display apparatus, in accordance with some embodiments;
FIG. 2 is a sectional view of a partial region of a display apparatus, in accordance with some embodiments;
FIG. 3A is a planar structural diagram of a display panel, in accordance with some embodiments;
FIG. 3B is another planar structural diagram of a display panel, in accordance with some embodiments;
FIG. 3C is a planar structural diagram of a partial region of a display panel, in accordance with some embodiments;
FIG. 4 is another planar structural diagram of a partial region of a display panel, in accordance with some embodiments;
FIG. 5 is a structural diagram of a light-emitting device in a display panel, in accordance with some embodiments;
FIG. 6 is another structural diagram of a light-emitting device in a display panel, in accordance with some embodiments;
FIG. 7 is a sectional view of the display panel shown in FIG. 3A taken along the section line m-m;
FIG. 8 is a sectional view of the display panel shown in FIG. 3A taken along the section line n-n;
FIG. 9A is a sectional view of the display panel shown in FIG. 3B taken along the section line o-o;
FIG. 9B is a sectional view of the display panel shown in FIG. 3B taken along the section line p-p;
FIG. 10 is a sectional view of a partial region of a driving layer in a display panel, in accordance with some embodiments;
FIG. 11 is a sectional view of a partial region of a first planarization layer in a display panel, in accordance with some embodiments;
FIG. 12 is a planar structural diagram of a first through hole of a first planarization layer, a pixel opening of a pixel definition layer, and a first electrode of a light-emitting device, in accordance with some embodiments;
FIG. 13 is a sectional view of partial regions of a first planarization layer, a pixel definition layer and a first electrode of a light-emitting device that are in a display panel, in accordance with some embodiments;
FIG. 14 is a film-layer structural diagram of a partial region of a secondary display area of a display panel, in accordance with some embodiments;
FIG. 15 is another film-layer structural diagram of a partial region of a secondary display area of a display panel, in accordance with some embodiments;
FIG. 16 is yet another film-layer structural diagram of a partial region of a secondary display area of a display panel, in accordance with some embodiments;
FIG. 17 is yet another film-layer structural diagram of a partial region of a secondary display area of a display panel, in accordance with some embodiments;
FIG. 18 is another sectional view of partial regions of a first planarization layer, a pixel definition layer and a first electrode of a light-emitting device that are in a display panel, in accordance with some embodiments;
FIG. 19 is a planar structural diagram of a support portion, a first through hole, a pixel opening, and a first electrode of a light-emitting device that are in a display panel, in accordance with some embodiments;
FIG. 20 is another planar structural diagram of a support portion, a first through hole, a pixel opening, and a first electrode of a light-emitting device that are in a display panel, in accordance with some embodiments;
FIG. 21 is a planar structural diagram of a first support portion, a first through hole, a pixel opening, and a first electrode of a first color light-emitting device that are in a display panel, in accordance with some embodiments;
FIG. 22 is another planar structural diagram of a first support portion, a first through hole, a pixel opening, and a first electrode of a first color light-emitting device that are in a display panel, in accordance with some embodiments;
FIG. 23 is a planar structural diagram of a second support portion, a first through hole, a pixel opening, and a first electrode of a second color light-emitting device that are in a display panel, in accordance with some embodiments;
FIG. 24 is another planar structural diagram of a second support portion, a first through hole, a pixel opening, and a first electrode of a second color light-emitting device that are in a display panel, in accordance with some embodiments;
FIG. 25 is a planar structural diagram of a first through hole, a pixel opening and a first electrode of a light-emitting device that are in a display panel, in accordance with some embodiments;
FIG. 26 is another planar structural diagram of a first through hole, a pixel opening and a first electrode of a light-emitting device that are in a display panel, in accordance with some embodiments;
FIG. 27 is a planar structural diagram of a partial region of a secondary display area of a display panel, in accordance with some embodiments;
FIG. 28 is another planar structural diagram of a partial region of a secondary display area of a display panel, in accordance with some embodiments;
FIG. 29 is yet another planar structural diagram of a partial region of a secondary display area of a display panel, in accordance with some embodiments;
FIG. 30 is yet another planar structural diagram of a partial region of a secondary display area of a display panel, in accordance with some embodiments;
FIG. 31 is yet another planar structural diagram of a first through hole, a pixel opening and a first electrode of a light-emitting device that are in a display panel, in accordance with some embodiments;
FIG. 32 is yet another film-layer structural diagram of a partial region of a secondary display area of a display panel, in accordance with some embodiments;
FIG. 33 is a flowchart of a manufacturing method for a display panel, in accordance with some embodiments;
FIG. 34 is a structural diagram of a display panel corresponding to step S1 in the flowchart of the manufacturing method for the display panel in FIG. 33;
FIG. 35 is a structural diagram of a display panel corresponding to step S2 in the flowchart of the manufacturing method for the display panel in FIG. 33;
FIG. 36 is a structural diagram of a display panel corresponding to step S3 in the flowchart of the manufacturing method for the display panel in FIG. 33;
FIG. 37 is a structural diagram of a display panel corresponding to step S4 in the flowchart of the manufacturing method for the display panel in FIG. 33; and
FIG. 38 is yet another film-layer structural diagram of a partial region of a secondary display area of a display panel, in accordance with some embodiments.

### DETAILED DESCRIPTION

The technical solutions in some embodiments of the present disclosure will be described clearly and completely below with reference to the accompanying drawings. Obviously, the described embodiments are merely some but not all embodiments of the present disclosure. All other embodiments obtained by a person of ordinary skill in the art based on the embodiments provided in the present disclosure shall be included in the protection scope of the present disclosure.

Unless the context requires otherwise, throughout the specification and the claims, the term "comprise" and other forms thereof such as the third-person singular form "comprises" and the present participle form "comprising" are construed as an open and inclusive meaning, i.e., "including, but not limited to". In the description of the specification, the terms such as "one embodiment", "some embodiments", "exemplary embodiments", "example", "specific example", or "some examples" are intended to indicate that specific features, structures, materials, or characteristics related to the embodiment(s) or example(s) are included in at least one embodiment or example of the present disclosure. Schematic representations of the above terms do not necessarily refer to the same embodiment(s) or example(s). In addition, the specific features, structures, materials or characteristics may be included in any one or more embodiments or examples in any suitable manner.

Hereinafter, the terms such as "first" and "second" are used for descriptive purposes only, but are not to be construed as indicating or implying the relative importance or implicitly indicating the number of indicated technical features. Thus, a feature defined with "first" or "second" may explicitly or implicitly include one or more of the features. In the description of the embodiments of the present disclosure, the term "a/the plurality of" means two or more unless otherwise specified.

In the description of some embodiments, the expressions "coupled" and "connected", as well as derivatives thereof may be used. The term "connected" should be understood in a broad sense. For example, the term "connected" may represent a fixed connection, a detachable connection, or a one-piece connection; alternatively, it may represent a direct connection or an indirect connection through an intermediate medium. The term "coupled", for example, indicates that two or more components are in direct physical or electrical contact. However, the term "coupled" or "communicatively coupled" may also indicate that two or more components are not in direct contact with each other, but still cooperate or interact with each other. The embodiments disclosed herein are not necessarily limited to the context herein.

The phrase "at least one of A, B and C" has the same meaning as the phrase "at least one of A, B or C", and they both include following combinations of A, B and C: only A, only B, only C, a combination of A and B, a combination of A and C, a combination of B and C, and a combination of A, B and C.

The phrase "A and/or B" includes following three combinations: only A, only B, and a combination of A and B.

As used herein, the term "if", depending on the context, is optionally construed as "when", "in a case where", "in response to determining", or "in response to detecting". Similarly, depending on the context, the phrase "if it is determined" or "if [a stated condition or event] is detected" is optionally construed as "in a case where it is determined", "in response to determining", "in a case where [the stated condition or event] is detected", or "in response to detecting [the stated condition or event]".

The phrase "applicable to" or "configured to" used herein means an open and inclusive expression, which does not exclude devices that are applicable to or configured to perform additional tasks or steps.

In addition, the phrase "based on" used is meant to be open and inclusive, since a process, step, calculation or other action that is "based on" one or more of the stated conditions or values may, in practice, be based on additional conditions or values other than those stated.

As used herein, the term such as "about", "substantially" or "approximately" includes a stated value and an average value within an acceptable range of deviation of a particular value, and the acceptable range of deviation is determined by a person of ordinary skill in the art in view of the measurement in question and errors associated with measurement of a particular quantity (i.e., the limitation of the measurement system).

As used herein, the term such as "parallel", "perpendicular", or "equal" includes a stated condition and a condition similar to the stated condition. A range of the similar condition is in an acceptable range of deviation, and the acceptable range of deviation is determined by a person of ordinary skill in the art in view of measurement in question and errors associated with the measurement of a particular quantity (i.e., the limitation of the measurement system). For example, the term "parallel" includes absolute parallelism and approximate parallelism, and an acceptable range of deviation of the approximate parallelism may be, for example, a deviation within 5°. The term "perpendicular" includes absolute perpendicularity and approximate perpendicularity, and an acceptable range of deviation of the approximate perpendicularity may also be, for example, a deviation within 5°. The term "equal" includes absolute equality and approximate equality, and an acceptable range of deviation of the approximate equality may be, for example, a difference between two equals being less than or equal to 5% of any one of the two equals.

It should be understood that, in a case where a layer or element is referred to as being on another layer or substrate, it may be that the layer or element is directly on the another layer or substrate, or there may be an intermediate layer between the layer or element and the another layer or substrate.

Exemplary embodiments are described herein with reference to sectional views and/or plan views as idealized exemplary drawings. In the accompanying drawings, thicknesses of layers and sizes of regions are enlarged for clarity. Variations in shape relative to the accompanying drawings due to, for example, manufacturing technologies and/or tolerances may be envisaged. Therefore, the exemplary embodiments should not be construed as being limited to the shapes of the regions shown herein, but including shape deviations due to, for example, manufacturing. For example, an etched region shown to have a rectangular shape generally has a feature of being curved. Therefore, the regions shown in the accompanying drawings are schematic in nature, and their shapes are not intended to show actual shapes of regions in an apparatus, and are not intended to limit the scope of the exemplary embodiments.

It should be noted that, symbols such as F/F1/F2/F3/F4 appearing in the accompanying drawings of the present disclosure indicate that the component can be F, or it can be F1, F2 or F3. For example, 41(F) indicates that the component 41 belongs to the component F. Other similar symbols appearing in the accompanying drawings also follow the above description.

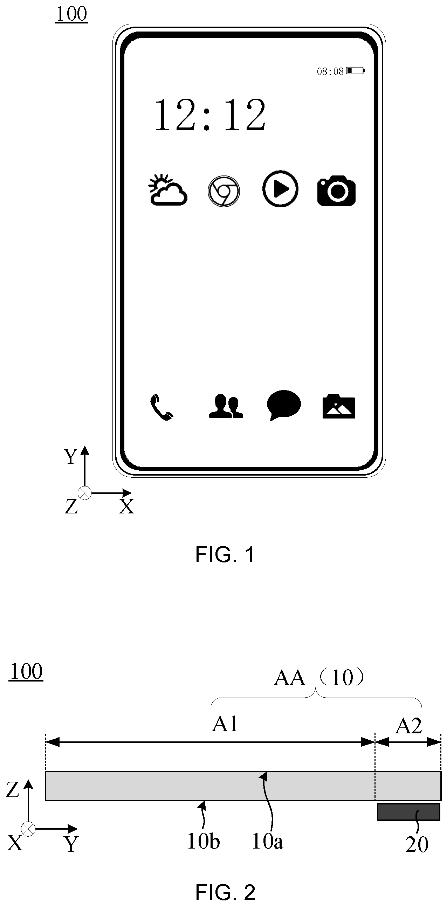

As shown in FIG. 1, some embodiments of the present disclosure provide a display apparatus 100.

For example, the display apparatus 100 may be any apparatus that displays images whether in motion (e.g., videos) or stationary (e.g., static images), and whether textual or graphical. More specifically, it is expected that the embodiments may be implemented in or associated with a variety of electronic apparatuses, and the variety of electronic apparatuses may include (but are not limited to), for example, mobile phones, wireless devices, personal digital assistants (PDAs), hand-held or portable computers, global positioning system (GPS) receivers/navigators, cameras, MP4 video players, video cameras, game consoles, watches, clocks, calculators, TV monitors, flat panel displays, computer monitors, car displays (e.g., odometer displays), navigators, cockpit controllers and/or displays, camera view displays (e.g., rearview camera displays in vehicles), electronic photos, electronic billboards or signs, projectors, architectural structures, packaging and aesthetic structures (e.g., displays for displaying images of a piece of jewelry). FIG. 1 illustrates an example where the display apparatus 100 is a mobile phone.

For example, the display apparatus 100 may be an electroluminescent display apparatus or a photoluminescent display apparatus. In a case where the display apparatus 100 is the electroluminescent display apparatus, the electroluminescent display apparatus may be an organic light-emitting diode (OLED) display apparatus or a quantum dot light-emitting diode (QLED) display apparatus. In a case where the display apparatus 100 is the photoluminescent display apparatus, the photoluminescent display apparatus may be a quantum dot photoluminescent display apparatus.

Some embodiments of the present disclosure are exemplarily described below by taking an example where the display apparatus 100 is an OLED display apparatus. However, the implementations of the present disclosure include but are not limited thereto, and any other display apparatus may also be considered as long as the same technical concept is applied.

In some embodiments, as shown in FIG. 2, which is a sectional view of a partial region of a display apparatus 100 in accordance with some embodiments, the display apparatus 100 includes a display panel 10 and optical device(s) 20.

For example, the optical device(s) 20 in the display apparatus 100 may include a camera, which enables the display apparatus 100 to achieve multiple different functions such as taking photos, recording videos, and face recognition.

The optical device(s) 20 in the display apparatus 100 may further include a sensor. For example, the optical device(s) 20 in the display apparatus 100 may include a fingerprint recognition sensor, which enables the display apparatus 100 to achieve functions such as fingerprint recognition.

In some embodiments, the display apparatus 100 can further include circuit boards (not shown in the figure). The circuit boards are electrically connected to the display panel 10, and configured to drive the display panel 10 to display images.

For example, the circuit boards in the display apparatus 100 include, but are not limited to, a printed circuit board (PCB) and a flexible printed circuit (FPC).

The display panel 10 will be described in detail below.

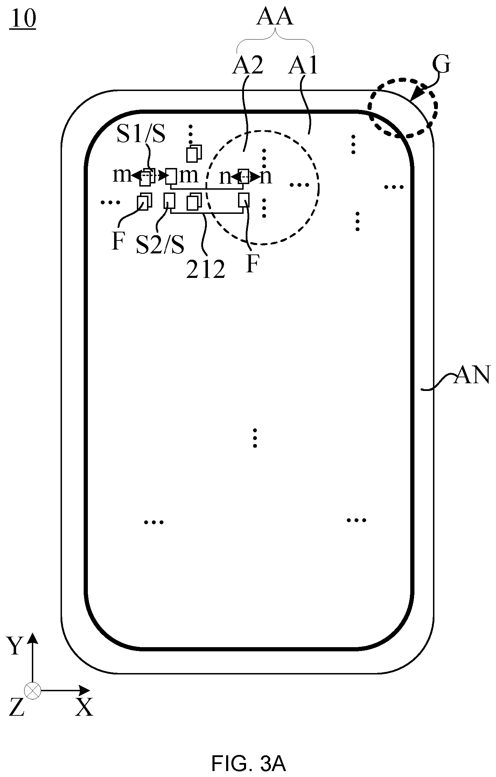

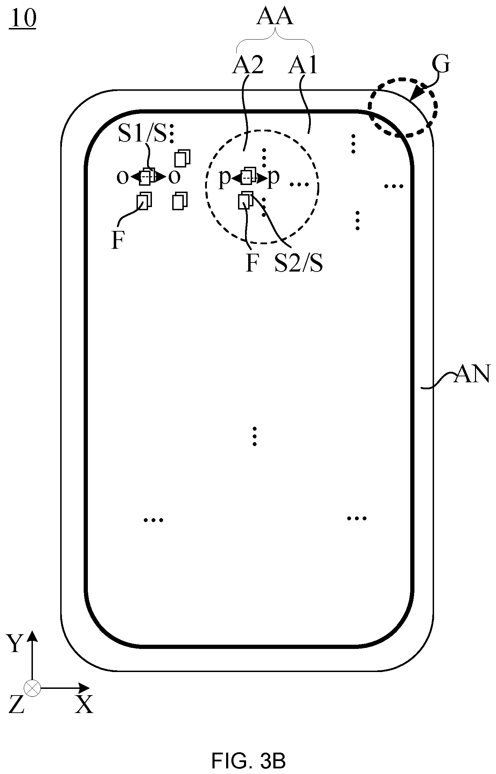

In some embodiments, as shown in FIGS. 3A and 3B, which are each a planar structural diagram of a display panel 10 in accordance with some embodiments, the display panel 10 may be of a rectangular structure.

It should be noted that, the "rectangular structure" means that a boundary of the display panel 10 is in a shape of a rectangle as a whole, but is not limited to a standard rectangle. That is, "rectangle" herein includes not only the standard rectangle but also a shape similar to the rectangle in consideration of process conditions. For example, as shown in FIGS. 3A and 3B, each of intersecting positions (i.e., corners G) of long sides and short sides of the rectangle is curved. That is, the corners are smooth. Thus, the boundary of the display panel 10 is in a shape of a round-corner rectangle in a plan view.

In some other embodiments, the display panel 10 may be of a circular structure or any other shape with corners.

Some embodiments of the present disclosure are exemplarily described by taking an example where the display panel 10 is of the rectangular structure. However, the implementations of the present disclosure include but are not limited to these, and the shape of the display panel 10 may also be considered as any other shape.

In some embodiments, with continued reference to FIGS. 3A and 3B, the display panel 10 has a display area AA for displaying images and a peripheral area AN located on at least one side of the display area AA.

For example, the peripheral area AN of the display panel 10 may be located on one side of the display area AA of the display panel 10.

Alternatively, the peripheral area AN of the display panel 10 may be located on opposite sides of the display area AA of the display panel 10.

Alternatively, with continued reference to FIGS. 3A and 3B, the peripheral area AN of the display panel 10 may surround the display area AA of the display panel 10.

It should be noted that the specific arrangement of the peripheral area AN of the display panel 10 is related to the specific design of the display panel 10 and can be designed according to actual needs. These are only for illustrative purposes and are not intended to limit the present disclosure.

For example, the peripheral area AN of the display panel 10 may be provided therein with a gate driving circuit (gate driver on array (GOA)) and control signal lines (e.g., clock signal lines and power supply voltage signal lines). However, the functions of the peripheral area AN of the display panel 10 include but are not limited to these.

For example, with continued reference to FIGS. 3A and 3B, the display area AA of the display panel 10 includes a main display area A1 and a secondary display area A2. The main display area A1 surrounds at least a part of the secondary display area A2.

For example, the main display area A1 of the display panel 10 surrounds a part of the secondary display area A2.

For another example, with continued reference to FIGS. 3A and 3B, the main display area A1 of the display panel 10 surrounds the entire secondary display area A2.

For example, with continued reference to FIG. 2 and in conjunction with FIGS. 3A and 3B, in the case where the display area AA of the display panel 10 includes the main display area A1 and the secondary display area A2, a light transmittance of the main display area A1 is less than a light transmittance of the secondary display area A2.

For example, in the case where the display area AA of the display panel 10 includes the main display area A1 and the secondary display area A2, both the main display area A1 and the secondary display area A2 are light-transmissive, and the light transmittance of the main display area A1 is relatively small, while the light transmittance of the secondary display area A2 is relatively large.

For another example, in the case where the display area AA of the display panel 10 includes the main display area A1 and the secondary display area A2, the main display area A1 is non-light-transmissive, and the secondary display area A2 is light-transmissive. That is, the light transmittance of the main display area A1 can be 0.

The optical device 20 in the display apparatus 100 can be located on a non-display surface 10b of the display panel 10, and overlap with the secondary display area A2 of the display panel 10 in a third direction Z (i.e., a thickness direction of the display panel 10).

It should be noted that a display surface 10a of the display panel 10 refers to a surface of the display panel 10 that can display images. The "non-display surface 10b of the display panel 10" refers to a surface opposite to the display surface 10a of the display panel 10.

The light transmittance of the secondary display area A2 of the display panel 10 is relatively large; and therefore, in a case where the optical device 20 (e.g., a camera) in the display apparatus 100 is located on the non-display surface 10b of the display panel 10 and overlaps with the secondary display area A2 of the display panel 10 in the third direction Z (i.e., the thickness direction of the display panel 10), more ambient light may pass through the secondary display area A2 of the display panel 10 and be received by the optical device 20 in the display apparatus 100. Thus, the optical device 20 in the display apparatus 100 may work normally.

In addition, by placing the optical device 20 (e.g., the camera) in the display apparatus 100 on the non-display surface 10b of the display panel 10, the placement hole in the display panel 10 for placing the optical device 20 in the display apparatus 100 may be eliminated, which is beneficial to achieving a full screen of the display panel 10.

It can be understood that in the case where the optical device 20 in the display apparatus 100 includes the camera, the camera is located on the non-display surface 10b of the display panel 10 and overlaps with the secondary display area A2 of the display panel 10 in the third direction Z (i.e., the thickness direction of the display panel 10), which can be called under-screen camera (full display with camera, FDC) technology.

In some embodiments, with continued reference to FIGS. 3A and 3B, the display panel 10 includes light-emitting devices F of at least one color. The light-emitting devices F of at least one color can be located in the display area AA of the display panel 10 (e.g., the main display area A1 and the secondary display area A2 within the display area AA), and the light-emitting device F is the smallest light-emitting unit within the display area AA of the display panel 10.

For example, the display panel 10 includes light-emitting devices F of one color. That is, the plurality of light-emitting devices F in the display area AA of the display panel 10 (e.g., the main display area A1 and secondary display area A2 within the display area AA) can emit light of the same color.

In the case where the display panel 10 includes the light-emitting devices F of one color, the display panel 10 can further include a color filter layer (not shown in the figure) disposed on a light-exit side of the plurality of light-emitting devices F. For example, the light-emitting devices F in the display area AA of the display panel 10 all emit white, red, green or blue light. After passing through the color filter layer, the light emitted by the light-emitting devices F is kept as the same color light for exiting or is converted into other colors of light for exiting. Thus, when the plurality of light-emitting devices F in the display area AA of the display panel 10 emit light of the same color, the display panel 10 may achieve multi-color light emission.

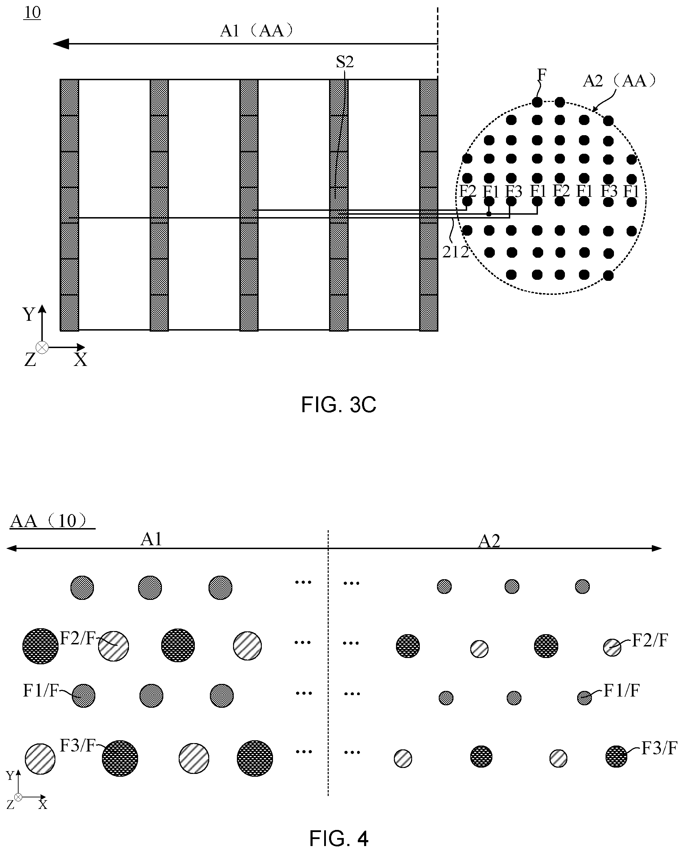

Alternatively, as shown in FIG. 4, which is a planar structural diagram of a partial region of a display panel 10 in accordance with some embodiments, the display panel 10 can include light-emitting devices F of multiple colors. That is, the plurality of light-emitting devices F in the display area AA of the display panel 10 can emit light of different colors.

For example, with continued reference to FIG. 4, the light-emitting devices F of multiple colors in the display area AA of the display panel 10 (e.g., the main display area A1 and secondary display area A2 within the display area AA) include first color light-emitting devices F1 for emitting first color light, second color light-emitting devices F2 for emitting second color light, and third color light-emitting devices F3 for emitting third color light, thereby achieving multi-color light emission of the display panel 10.

The first color light-emitting device F1 can be a green light-emitting device for emitting green light. The second color light-emitting device F2 can be a red light-emitting device for emitting red light. The third color light-emitting device F3 can be a blue light-emitting device for emitting blue light.

Alternatively, the first color light-emitting device F1 can be a red light-emitting device or a blue light-emitting device. The second color light-emitting device F2 can be a green light-emitting device or a blue light-emitting device. The third color light-emitting device F3 can be a red light-emitting device or a green light-emitting device.

Some embodiments of the present disclosure are exemplarily described below by taking an example where the display panel 10 includes the light-emitting devices F of multiple colors, that is, the plurality of light-emitting devices F in the display area AA of the display panel 10 emit light of different colors.

For example, with continued reference to FIGS. 3A, 3B and 4, the light-emitting devices F of at least one color in the display panel 10 are arranged in an array along a row direction X and a column direction Y.

For example, with continued reference to FIGS. 3A, 3B and 4, light-emitting devices F of at least one color located in the main display area A1 of the display panel 10 are arranged in an array along the row direction X and the column direction Y.

For another example, with continued reference to FIGS. 3A, 3B and 4, light-emitting devices F of at least one color located in the secondary display area A2 of the display panel 10 are arranged in an array along the row direction X and the column direction Y.

In some examples, with continued reference to FIG. 4, in a case where the light-emitting devices F of at least one color located in the main display area A1 of the display panel 10 are arranged in an array along the row direction X and the column direction Y, and the light-emitting devices F of at least one color located in the main display area A1 of the display panel 10 includes first color light-emitting devices F1, second color light-emitting devices F2 and third color light-emitting devices F3, in the main display area A1 of the display panel 10, the second color light-emitting devices F2 and the third color light-emitting devices F3 can be alternately arranged in the same row along the row direction X and can be alternately arranged in the same column along the column direction Y. The first color light-emitting devices F1 can be arranged sequentially in the same row along the row direction X and can be arranged sequentially in the same column along the column direction Y. The rows where the second color light-emitting devices F2 and the third color light-emitting devices F3 are located are alternately arranged with the rows where the first color light-emitting devices F1 are located, and the columns where the second color light-emitting devices F2 and the third color light-emitting devices F3 are located are alternately arranged with the columns where the first color light-emitting devices F1 are located.

In some examples, with continued reference to FIG. 4, in a case where the light-emitting devices F of at least one color located in the secondary display area A2 of the display panel 10 are arranged in an array along the row direction X and the column direction Y, and the light-emitting devices F of at least one color located in the secondary display area A2 of the display panel 10 includes first color light-emitting devices F1, second color light-emitting devices F2 and third color light-emitting devices F3, in the secondary display area A2 of the display panel 10, the second color light-emitting devices F2 and the third color light-emitting devices F3 can be alternately arranged in the same row along the row direction X and can be alternately arranged in the same column along the column direction Y. The first color light-emitting devices F1 can be arranged sequentially in the same row along the row direction X and can be arranged sequentially in the same column along the column direction Y. The rows where the second color light-emitting devices F2 and the third color light-emitting devices F3 are located are alternately arranged with the rows where the first color light-emitting devices F1 are located, and the columns where the second color light-emitting devices F2 and the third color light-emitting devices F3 are located are alternately arranged with the columns where the first color light-emitting devices F1 are located.

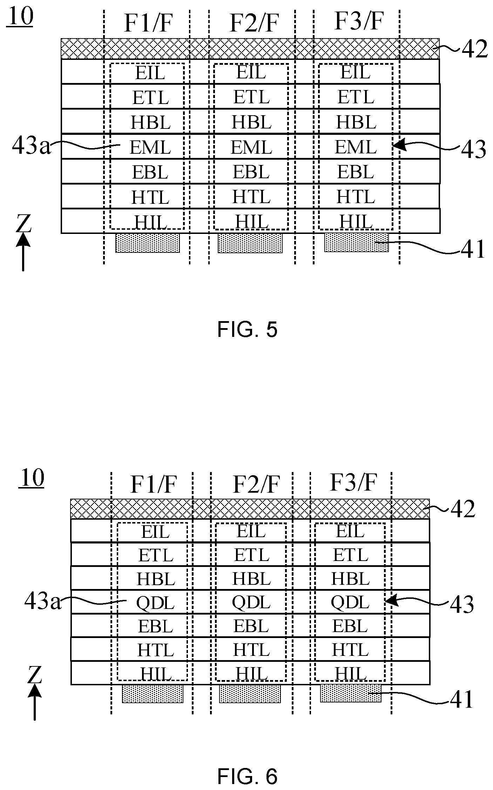

In some embodiments, as shown in FIGS. 5 and 6, which are each a structural diagram of a light-emitting device F in a display panel 10 in accordance with some embodiments, the light-emitting device F in the display panel 10 includes a first electrode 41, a light-emitting portion 43 and a second electrode 42 that are stacked sequentially. The first electrode 41 and the second electrode 42 can provide carriers such as electrons and holes to the light-emitting portion 43, so that the light-emitting portion 43 emits light.

For example, with continued reference to FIGS. 5 and 6, one of the first electrode 41 and the second electrode 42 serves as an anode of the light-emitting device F (e.g., the first color light-emitting device F1, second color light-emitting device F2, and third color light-emitting device F3), and the other of the first electrode 41 and the second electrode 42 serves as a cathode of the light-emitting device F (e.g., the first color light-emitting device F1, second color light-emitting device F2, and third color light-emitting device F3).

For example, with continued reference to FIGS. 5 and 6, the first electrode 41 serves as the anode of the light-emitting device F (e.g., the first color light-emitting device F1, second color light-emitting device F2, and third color light-emitting device F3), and the second electrode 42 serves as the cathode of the light-emitting device F (e.g., the first color light-emitting device F1, second color light-emitting device F2, and third color light-emitting device F3).

In the case where the first electrode 41 serves as the anode of the light-emitting device F (e.g., the first color light-emitting device F1, second color light-emitting device F2, and third color light-emitting device F3), and the second electrode 42 serves as the cathode of the light-emitting device F (e.g., the first color light-emitting device F1, second color light-emitting device F2, and third color light-emitting device F3), when voltages are applied to the first electrode 41 and the second electrode 42, holes injected from the first electrode 41 may be transported to the light-emitting portion 43 of the light-emitting device F, and electrons injected from the second electrode 42 may also be transported to the light-emitting portion 43 of the light-emitting device F. The electrons and holes, as charge carriers, recombine in the light-emitting portion 43 of the light-emitting device F to generate excitons, and the excitons emit light when transitioning from the excited state to the ground state, thereby causing the light-emitting portion 43 to emit light.

For example, a material used for forming the first electrode 41 of the light-emitting device F includes a metal material. For example, the material used for forming the first electrode 41 of the light-emitting device F includes any one or more of magnesium (Mg), silver (Ag), copper (Cu), aluminum (Al), titanium (Ti), and molybdenum (Mo).

The material used for forming the first electrode 41 of the light-emitting device F may also include an alloy of the above metal material. For example, the material used for forming the first electrode 41 of the light-emitting device F includes aluminum-neodymium alloy (AlNd) or molybdenum-niobium alloy (MoNb).

For example, the first electrode 41 of the light-emitting device F can be of a single-layer structure.

Alternatively, the first electrode 41 of the light-emitting device F can be of a multilayer composite structure. For example, the first electrode 41 of the light-emitting device F is of a Ti/Al/Ti structure. For another example, the first electrode 41 of the light-emitting device F is of a stacked structure formed by a metal material and a transparent conductive material, such as ITO/Ag/ITO, or Mo/AlNd/ITO.

For example, a material used for forming the second electrode 42 of the light-emitting device F includes any one or more of magnesium (Mg), silver (Ag), and aluminum (Al).

The material used for forming the second electrode 42 of the light-emitting device F may also include an alloy made of any one or more of magnesium (Mg), silver (Ag), and aluminum (Al).

The material used for forming the second electrode 42 of the light-emitting device F may also include a transparent conductive material. For example, the material used for forming the second electrode 42 of the light-emitting device F includes indium zinc oxide (IZO).

For example, with continued reference to FIGS. 5 and 6, the light-emitting portion 43 of the light-emitting device F includes a light-emitting layer 43a.

For example, with continued reference to FIG. 5, the display panel 10 is an organic light-emitting diode (OLED) display panel. In the case where the display panel 10 is the organic light-emitting diode (OLED) display panel, the light-emitting layer 43a in the light-emitting portion 43 of the light-emitting device F can include an organic light-emitting layer (EML). The organic light-emitting layer (EML) may include a host material for the light-emitting layer and a guest material for the light-emitting layer, and the guest material for the light-emitting layer may be a fluorescent dopant or a phosphorescent dopant.

For another example, with continued reference to FIG. 6, the display panel 10 is a quantum dot light-emitting diode (QLED) display panel. In the case where the display panel 10 is the quantum dot light-emitting diode (QLED) display panel, the light-emitting layer 43a in the light-emitting portion 43 of the light-emitting device F can include a quantum dot layer (QDL). The quantum dot layer (QDL) may contain quantum dot particles that may be interconnected through surface-modifying groups.

For example, with continued reference to FIGS. 5 and 6, the light-emitting portion 43 of the light-emitting device F can further include one or more of the following: a hole injection layer (HIL), a hole transport layer (HTL), an electron block layer (EBL), a hole block layer (HBL), an electron transport layer (ETL), and an electron injection layer (EIL).

In some embodiments, with continued reference to FIGS. 3A and 3B, the display panel 10 further includes a plurality of pixel circuits S. The pixel circuit S can be electrically connected to the light-emitting device F in the display panel 10 to drive the light-emitting device F in the display panel 10 to emit light.

For example, with continued reference to FIGS. 3A and 3B, the plurality of pixel circuits S in the display panel 10 include first pixel circuits S1. The first pixel circuits S1 can be located in the main display area A1 of the display panel 10, and the light-emitting devices F located in the main display area A1 of the display panel 10 can be electrically connected to corresponding first pixel circuits S1. The light-emitting device F located in the main display area A1 of the display panel 10 overlaps with a corresponding first pixel circuit S1 in the third direction Z (i.e., the thickness direction of the display panel 10).

For example, with continued reference to FIG. 3A, the plurality of pixel circuits S in the display panel 10 further include second pixel circuits S2. The second pixel circuits S2 can be located in the main display area A1 of the display panel 10, and the light-emitting devices F located in the secondary display area A2 of the display panel 10 can be electrically connected to corresponding second pixel circuits S2 (for example, the light-emitting devices F located in the secondary display area A2 of the display panel 10 can be electrically connected to corresponding second pixel circuits S2 through conductive lines 212). The light-emitting device F located in the secondary display area A2 of the display panel 10 does not overlap with a corresponding second pixel circuit S2 in the third direction Z (i.e., the thickness direction of the display panel 10).

By arranging the second pixel circuits S2, which are connected to the light-emitting devices F located in the secondary display area A2 of the display panel 10, in the main display area A1 of the display panel 10, it is possible to prevent the second pixel circuits S2 from occupying the space of the secondary display area A2 of the display panel 10. This may reduce the obstruction of ambient light passing through the secondary display area A2 of the display panel 10 and help to improve the light transmittance of the secondary display area A2 of the display panel 10.

Alternatively, with continued reference to FIG. 3B, the second pixel circuits S2 can be located in the secondary display area A2 of the display panel 10, and the light-emitting devices F located in the secondary display area A2 of the display panel 10 can be electrically connected to corresponding second pixel circuits S2. The light-emitting device F located in the secondary display area A2 of the display panel 10 overlaps with a corresponding second pixel circuit S2 in the third direction Z (i.e., the thickness direction of the display panel 10).

By arranging the second pixel circuits S2, which are connected to the light-emitting devices F located in the secondary display area A2 of the display panel 10, in the secondary display area A2 of the display panel 10, it is possible to prevent the second pixel circuits S2 from occupying the space of the main display area A1 of the display panel 10. As a result, more light-emitting devices F may be disposed in the main display area A1 of the display panel 10, which is beneficial to improving the pixel density (pixels per inch, PPI) of the main display area A1 of the display panel 10.

For example, with continued reference to FIGS. 3A and 3B, the plurality of pixel circuits S and the plurality of light-emitting devices F in the display panel 10 can be in a one-to-one driving relationship.

For example, with continued reference to FIGS. 3A and 3B, a single light-emitting device F located in the main display area A1 of the display panel 10 is electrically connected to one first pixel circuit S1 corresponding thereto.

For another example, with continued reference to FIGS. 3A and 3B, a single light-emitting device F located in the secondary display area A2 of the display panel 10 is electrically connected to one second pixel circuit S2 corresponding thereto.

Alternatively, as shown in FIG. 3C, which is a planar structural diagram of a partial region of a display panel 10 in accordance with some embodiments, the plurality of pixel circuits S and the plurality of light-emitting devices F in the display panel 10 can be in a one-to-many driving relationship. That is, a single pixel circuit S in the display panel 10 can be electrically connected to multiple light-emitting devices F and configured to drive the multiple light-emitting devices F to emit light.

For example, with continued reference to FIG. 3C, two light-emitting devices F located in the secondary display area A2 of the display panel 10 are electrically connected to a corresponding second pixel circuit S2. Specifically, with continued reference to FIG. 3C, in the case where the display panel 10 includes the light-emitting devices F of multiple colors (that is, the plurality of light-emitting devices F in the display panel 10 emit light of different colors), two adjacent light-emitting devices F for emitting light of the same color (e.g., first color light-emitting devices F1) located in the secondary display area A2 of the display panel 10 are electrically connected to a corresponding second pixel circuit S2. In other words, two adjacent light-emitting devices F for emitting light of the same color (e.g., first color light-emitting devices F1) located in the secondary display area A2 of the display panel 10 are driven to emit light by the same second pixel circuit S2.

The light-emitting devices F (e.g., the first color light-emitting devices F1, second color light-emitting devices F2 and third color light-emitting devices F3) and the pixel circuits S (e.g., the first pixel circuits S1 and second pixel circuits S2) in the display panel 10 may be arranged in a film layer structure of the display panel 10. The film layer structure of the display panel 10 will be described in detail below.

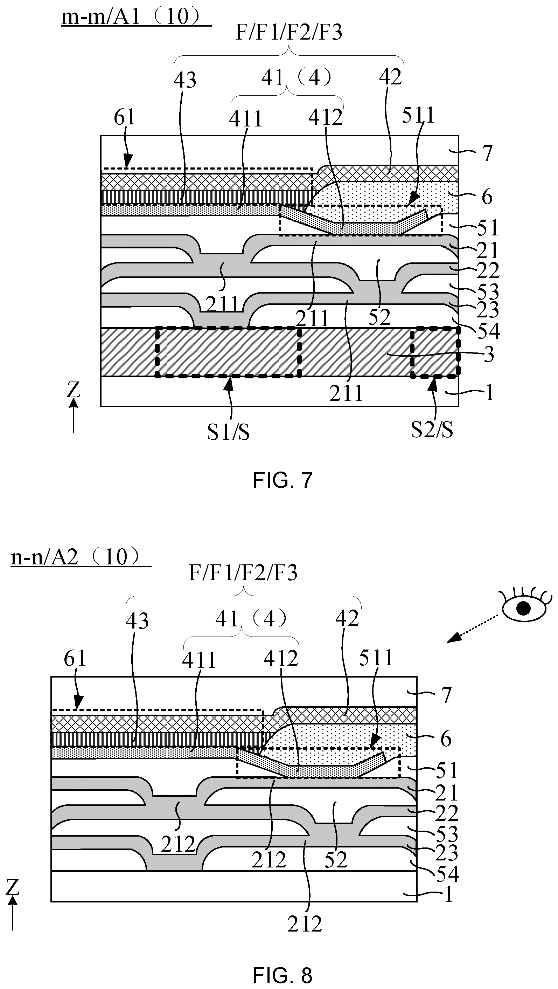

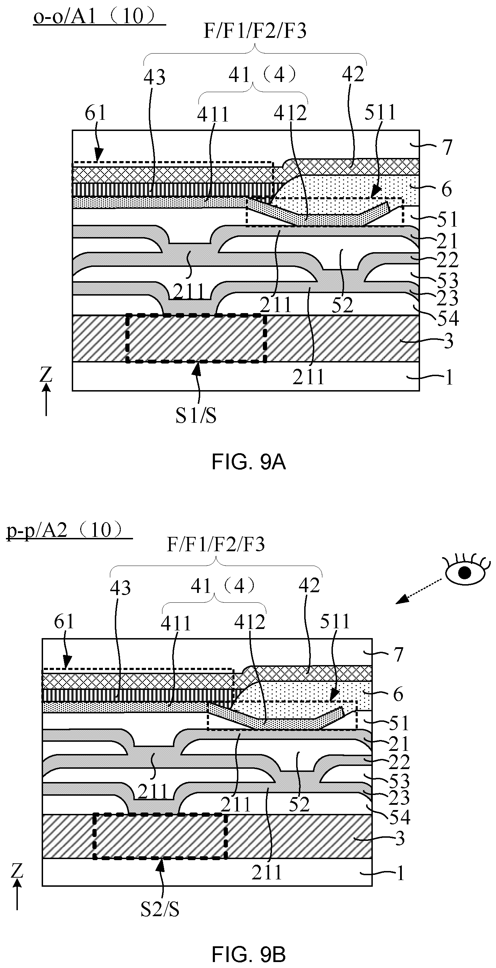

In some embodiments, as shown in FIGS. 7, 8, 9A and 9B (where FIG. 7 is a sectional view of the display panel 10 shown in FIG. 3A taken along the section line m-m, FIG. 8 is a sectional view of the display panel 10 shown in FIG. 3A taken along the section line n-n, FIG. 9A is a sectional view of the display panel 10 shown in FIG. 3B taken along the section line o-o, and FIG. 9B is a sectional view of the display panel 10 shown in FIG. 3B taken along the section line p-p), the display panel 10 can include a substrate 1.

For example, a material of the substrate 1 in the display panel 10 may include an inorganic material. For example, the material of the substrate 1 in the display panel 10 includes a glass material such as soda-lime glass, quartz glass, or sapphire glass.

Alternatively, the material of the substrate 1 in the display panel 10 may include an organic material. For example, the material of the substrate 1 in the display panel 10 includes one or more of polymethyl methacrylate, polyvinyl alcohol, polyvinyl phenol, polyether sulfone, polyimide, polyamide, polyacetal, polycarbonate, polyethylene terephthalate, and polyethylene naphthalate.

Alternatively, the material of the substrate 1 in the display panel 10 may include both organic and inorganic materials.

In some embodiments, with continued reference to FIGS. 7, 9A and 9B, the display panel 10 can further include a driving layer 3. The driving layer 3 is located on a side of the substrate 1 in the display panel 10. The pixel circuits S (e.g., the first pixel circuits S1 and second pixel circuits S2) in the display panel 10 can be arranged in the driving layer 3.

For example, with continued reference to FIG. 7 and in conjunction with FIG. 3A, in the case where the first pixel circuits S1 and the second pixel circuits S2 in the display panel 10 are all located in the main display area A1 of the display panel 10, the first pixel circuits S1 and the second pixel circuits S2 can all be arranged in the driving layer 3 within the main display area A1 of the display panel 10.

Alternatively, with continued reference to FIGS. 9A and 9B, in the case where the first pixel circuits S1 in the display panel 10 are located in the main display area A1 of the display panel 10, and the second pixel circuits S2 in the display panel 10 are located in the secondary display area A2 of the display panel 10, the first pixel circuits S1 can be arranged in the driving layer 3 within the main display area A1 of the display panel 10, and the second pixel circuits S2 can be arranged in the driving layer 3 within the secondary display area A2 of the display panel 10.

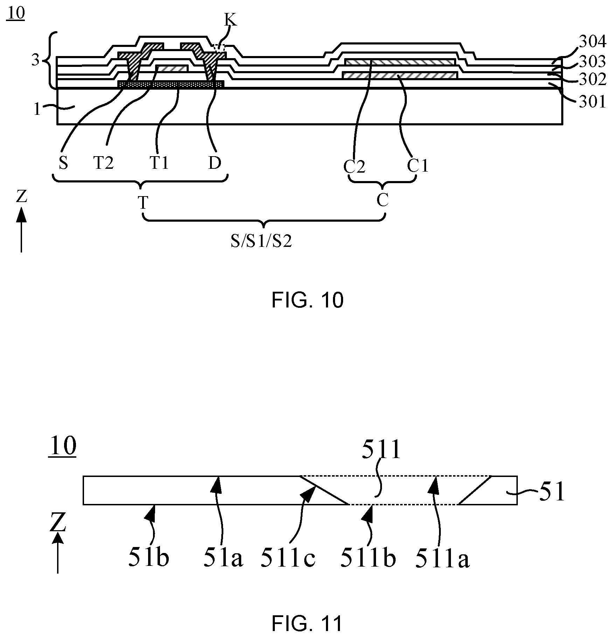

For example, as shown in FIG. 10, which is a sectional view of a partial region of a driving layer 3 in a display panel 10 in accordance with some embodiments, the driving layer 3 in the display panel 10 may include a semiconductor layer, a first gate metal layer, a second gate metal layer and a source-drain metal layer that are sequentially stacked in a direction away from the substrate 1 of the display panel 10. A first gate insulating layer 301 may be provided between the semiconductor layer and the first gate metal layer, a second gate insulating layer 302 may be provided between first gate metal layer and the second gate metal layer, an interlayer insulating layer 303 may be provided between the second gate metal layer and the source-drain metal layer, and a passivation layer 304 may be provided on a side of the source-drain metal layer away from the substrate 1. The first gate insulating layer 301, the second gate insulating layer 302, the interlayer insulating layer 303, and the passivation layer 304 may be inorganic insulating layers.

With continued reference to FIG. 10, the pixel circuits S (e.g., the first pixel circuits S1 and second pixel circuits S2) in the display panel 10 can each include a thin film transistor T and a capacitor C.

The semiconductor layer of the driving layer 3 may include at least an active layer T1 of the thin film transistor T. The first gate metal layer of the driving layer 3 may include at least a gate T2 of the thin film transistor T and a first electrode plate C1 of the capacitor C. An orthographic projection of the gate T2 of the thin film transistor T on the substrate 1 may cover an orthographic projection of a channel region of the active layer T1 on the substrate 1. The second gate metal layer may include at least a second electrode plate C2 of the capacitor C. Orthographic projections, on the substrate 1, of the second electrode plate C2 and the first electrode plate C1 of the capacitor C may at least partially overlap, for example, they may coincide. The source-drain metal layer may include at least a source S and a drain D of the thin film transistor T. A material of the active layer T1 of the thin film transistor T may include polysilicon and/or metal oxide, and a material of the gate T2 of the thin film transistor T may include metal such as aluminum, titanium, or cobalt, or an alloy.

With continued reference to FIG. 10, in the driving layer 3 of the display panel 10, via holes K can be provided on a side, away from the substrate 1, of drains D of thin film transistors T in the pixel circuits S (e.g., the first pixel circuits S1 and second pixel circuits S2). The light-emitting devices F in FIGS. 7, 8, 9A and 9B can be electrically connected to the corresponding pixel circuits S (e.g., the first pixel circuits S1 and second pixel circuits S2) in the driving layer 3 through the via holes K. Thus, the pixel circuits S (e.g., the first pixel circuits S1 and second pixel circuits S2) may drive the light-emitting devices F to emit light.

In some embodiments, with continued reference to FIGS. 7, 8, 9A and 9B, the display panel 10 can further include a first conductive layer 21. The first conductive layer 21 is located on the side of the substrate 1.

For example, with continued reference to FIG. 7, in the case where the first pixel circuits S1 and the second pixel circuits S2 in the display panel 10 are all located in the main display area A1 of the display panel 10 (that is, the driving layer 3 is arranged in the main display area A1 of the display panel 10), the first conductive layer 21 can be located on a side of the driving layer 3 away from the substrate 1 in the main display area A1 of the display panel 10.

Alternatively, with continued reference to FIGS. 9A and 9B, in the case where the first pixel circuits S1 in the display panel 10 are located in the main display area A1 of the display panel 10, and the second pixel circuits S2 in the display panel 10 are located in the secondary display area A2 of the display panel 10 (that is, the driving layer 3 is arranged in both the main display area A1 and the secondary display area A2 of the display panel 10), the first conductive layer 21 can be located on a side of the driving layer 3 away from the substrate 1 in both the main display area A1 and the secondary display area A2 of the display panel 10.

For example, a material of the first conductive layer 21 in the display panel 10 may include a transparent conductive material. For example, the material of the first conductive layer 21 in the display panel 10 includes indium tin oxide (ITO).

The material of the first conductive layer 21 in the display panel 10 includes the transparent conductive material, which may prevent the first conductive layer 21 located in the secondary display area A2 of the display panel 10 from blocking ambient light passing through the secondary display area A2 of the display panel 10, thereby allowing more ambient light to pass through the secondary display area A2 of the display panel 10, and helping to improve the light transmittance of the secondary display area A2 of the display panel 10.

For example, with continued reference to FIGS. 7 and 9A, the first conductive layer 21 in the display panel 10 can include conductive portions 211. The light-emitting device F located in the main display area A1 of the display panel 10 can be electrically connected to the first pixel circuit S1 in the display panel 10 through a conductive portion 211 of the first conductive layer 21.

For example, with continued reference to FIGS. 8 and in conjunction with FIG. 7, in the case where the second pixel circuits S2 in the display panel 10 are located in the main display area A1 of the display panel 10, and the light-emitting devices F located in the secondary display area A2 of the display panel 10 are electrically connected to the corresponding second pixel circuits S2, the first conductive layer 21 in the display panel 10 can include conductive lines 212. The light-emitting device F located in the secondary display area A2 of the display panel 10 can be electrically connected to the second pixel circuit S2 in the display panel 10 through a conductive line 212 of the first conductive layer 21.

Alternatively, with continued reference to FIG. 9B, in the case where the second pixel circuits S2 in the display panel 10 are located in the secondary display area A2 of the display panel 10, and the light-emitting devices F located in the secondary display area A2 of the display panel 10 are electrically connected to the corresponding second pixel circuits S2, the first conductive layer 21 in the display panel 10 can include conductive portions 211. The light-emitting device F located in the secondary display area A2 of the display panel 10 can be electrically connected to the second pixel circuit S2 in the display panel 10 through a conductive portion 211 of the first conductive layer 21.

In some embodiments, with continued reference to FIGS. 7, 8, 9A and 9B, the display panel 10 can further include a second conductive layer 22 and a second planarization layer 52. The second conductive layer 22 can be located on a side, close to the substrate 1, of the first conductive layer 21 in the display panel 10, and the second planarization layer 52 can be located between the second conductive layer 22 and the first conductive layer 21 in the display panel 10.

With continued reference to FIGS. 7 and 9A, the second conductive layer 22 in the display panel 10 can include conductive portions 211. In a case where the display panel 10 includes the first conductive layer 21 and the second conductive layer 22, the light-emitting device F located in the main display area A1 of the display panel 10 can be electrically connected to the first pixel circuit S1 in the display panel 10 through a conductive portion 211 of the first conductive layer 21 and/or a conductive portion 211 of the second conductive layer 22.

For example, in the case where the display panel 10 includes the first conductive layer 21 and the second conductive layer 22, the light-emitting device F located in the main display area A1 of the display panel 10 is electrically connected to the first pixel circuit S1 in the display panel 10 through a conductive portion 211 of the first conductive layer 21.

Alternatively, in the case where the display panel 10 includes the first conductive layer 21 and the second conductive layer 22, the light-emitting device F located in the main display area A1 of the display panel 10 may be electrically connected to the first pixel circuit S1 in the display panel 10 through a conductive portion 211 of the first conductive layer 21 and a conductive portion 211 of the second conductive layer 22.

For example, in the case where the display panel 10 includes the first conductive layer 21 and the second conductive layer 22, some of the light-emitting devices F located in the main display area A1 of the display panel 10 are electrically connected to first pixel circuits S1 in the display panel 10 through conductive portions 211 of the first conductive layer 21, and some of the light-emitting devices F located in the main display area A1 of the display panel 10 are electrically connected to first pixel circuits S1 in the display panel 10 through conductive portions 211 of the first conductive layer 21 and conductive portions 211 of the second conductive layer 22.

With continued reference to FIG. 8 and in conjunction with FIG. 7, in the case where the display panel 10 includes the first conductive layer 21 and the second conductive layer 22, the second pixel circuits S2 in the display panel 10 are located in the main display area A1 of the display panel 10, and the light-emitting devices F located in the secondary display area A2 of the display panel 10 are electrically connected to the corresponding second pixel circuits S2, the second conductive layer 22 in the display panel 10 can include conductive lines 212. The light-emitting device F located in the secondary display area A2 of the display panel 10 can be electrically connected to the second pixel circuit S2 in the display panel 10 through a conductive line 212 of the first conductive layer 21 and/or a conductive line 212 of the second conductive layer 22.

For example, in the case where the display panel 10 includes the first conductive layer 21 and the second conductive layer 22, the second pixel circuits S2 in the display panel 10 are located in the main display area A1 of the display panel 10, and the light-emitting devices F located in the secondary display area A2 of the display panel 10 are electrically connected to the corresponding second pixel circuits S2, the light-emitting device F located in the secondary display area A2 of the display panel 10 is electrically connected to the second pixel circuit S2 in the display panel 10 through a conductive line 212 of the first conductive layer 21.

Alternatively, in the case where the display panel 10 includes the first conductive layer 21 and the second conductive layer 22, the second pixel circuits S2 in the display panel 10 are located in the main display area A1 of the display panel 10, and the light-emitting devices F located in the secondary display area A2 of the display panel 10 are electrically connected to the corresponding second pixel circuits S2, the light-emitting device F located in the secondary display area A2 of the display panel 10 may be electrically connected to the second pixel circuit S2 in the display panel 10 through a conductive line 212 of the first conductive layer 21 and a conductive line 212 of the second conductive layer 22.

For example, in the case where the display panel 10 includes the first conductive layer 21 and the second conductive layer 22, the second pixel circuits S2 in the display panel 10 are located in the main display area A1 of the display panel 10, and the light-emitting devices F located in the secondary display area A2 of the display panel 10 are electrically connected to the corresponding second pixel circuits S2, some of the light-emitting devices F located in the secondary display area A2 of the display panel 10 are electrically connected to second pixel circuits S2 in the display panel 10 through conductive lines 212 of the first conductive layer 21, and some of the light-emitting devices F located in the secondary display area A2 of the display panel 10 are electrically connected to second pixel circuits S2 in the display panel 10 through conductive lines 212 of the first conductive layer 21 and conductive lines 212 of the second conductive layer 22. With continued reference to FIG. 9B, in the case where the display panel 10 includes the first conductive layer 21 and the second conductive layer 22, the second pixel circuits S2 in the display panel 10 are located in the secondary display area A2 of the display panel 10, and the light-emitting devices F located in the secondary display area A2 of the display panel 10 are electrically connected to the corresponding second pixel circuits S2, the second conductive layer 22 in the display panel 10 can include conductive portions 211. The light-emitting device F located in the secondary display area A2 of the display panel 10 can be electrically connected to the second pixel circuit S2 in the display panel 10 through a conductive portion 211 of the first conductive layer 21 and/or a conductive portion 211 of the second conductive layer 22.

For example, in the case where the display panel 10 includes the first conductive layer 21 and the second conductive layer 22, the second pixel circuits S2 in the display panel 10 are located in the secondary display area A2 of the display panel 10, and the light-emitting devices F located in the secondary display area A2 of the display panel 10 are electrically connected to the corresponding second pixel circuits S2, the light-emitting device F located in the secondary display area A2 of the display panel 10 is electrically connected to the second pixel circuit S2 in the display panel 10 through a conductive portion 211 of the first conductive layer 21.

Alternatively, in the case where the display panel 10 includes the first conductive layer 21 and the second conductive layer 22, the second pixel circuits S2 in the display panel 10 are located in the secondary display area A2 of the display panel 10, and the light-emitting devices F located in the secondary display area A2 of the display panel 10 are electrically connected to the corresponding second pixel circuits S2, the light-emitting device F located in the secondary display area A2 of the display panel 10 may be electrically connected to the second pixel circuit S2 in the display panel 10 through a conductive portion 211 of the first conductive layer 21 and a conductive portion 211 of the second conductive layer 22.

For example, in the case where the display panel 10 includes the first conductive layer 21 and the second conductive layer 22, the second pixel circuits S2 in the display panel 10 are located in the secondary display area A2 of the display panel 10, and the light-emitting devices F located in the secondary display area A2 of the display panel 10 are electrically connected to the corresponding second pixel circuits S2, some of the light-emitting devices F located in the secondary display area A2 of the display panel 10 are electrically connected to second pixel circuits S2 in the display panel 10 through conductive portions 211 of the first conductive layer 21, and some of the light-emitting devices F located in the secondary display area A2 of the display panel 10 are electrically connected to second pixel circuits S2 in the display panel 10 through conductive portions 211 of the first conductive layer 21 and conductive portions 211 of the second conductive layer 22.

For example, a material of the second conductive layer 22 in the display panel 10 may include a transparent conductive material. For example, the material of the second conductive layer 22 in the display panel 10 includes indium tin oxide (ITO).

The material of the second conductive layer 22 in the display panel 10 includes the transparent conductive material, which may prevent the second conductive layer 22 located in the secondary display area A2 of the display panel 10 from blocking ambient light passing through the secondary display area A2 of the display panel 10, thereby allowing more ambient light to pass through the secondary display area A2 of the display panel 10, and helping to improve the light transmittance of the secondary display area A2 of the display panel 10.

It should be noted that, with continued reference to FIGS. 7, 8, 9A and 9B as well as in conjunction with FIG. 10, in the case where the light-emitting device F in the display panel 10 (e.g., the light-emitting device F located in the main display area A1 of the display panel 10 or the light-emitting device F located in the secondary display area A2 of the display panel 10) is electrically connected to the corresponding pixel circuit S (e.g., the first pixel circuit S1 and the second pixel circuit S2) in the driving layer 3 through the conductive portion 211 or the conductive line 212, the conductive portion 211 or the conductive line 212 may be electrically connected to the corresponding pixel circuit S (e.g., the first pixel circuit S1 and the second pixel circuit S2) in the driving layer 3 through the via hole K in the driving layer 3.

In some embodiments, with continued reference to FIGS. 7, 8, 9A and 9B, the display panel 10 can further include a third conductive layer 23, a third planarization layer 53 and a fourth planarization layer 54. The third conductive layer 23 can be located on a side, close to the substrate 1, of the second conductive layer 22 in the display panel 10. The third planarization layer 53 can be located between the third conductive layer 23 and the second conductive layer 22 in the display panel 10. The fourth planarization layer 54 can be located on a side, close to the substrate 1, of the third conductive layer 23 in the display panel 10.

With continued reference to FIGS. 7 and 9A, the third conductive layer 23 in the display panel 10 can include conductive portions 211. In the case where the display panel 10 includes the first conductive layer 21, the second conductive layer 22 and the third conductive layer 23, the light-emitting device F located in the main display area A1 of the display panel 10 can be electrically connected to the first pixel circuit S1 in the display panel 10 through a conductive portion 211 of the first conductive layer 21 and/or a conductive portion 211 of the second conductive layer 22 and/or a conductive portion 211 of the third conductive layer 23.

For example, in the case where the display panel 10 includes the first conductive layer 21, the second conductive layer 22 and the third conductive layer 23, the light-emitting device F located in the main display area A1 of the display panel 10 is electrically connected to the first pixel circuit S1 in the display panel 10 through a conductive portion 211 of the first conductive layer 21.

Alternatively, in the case where the display panel 10 includes the first conductive layer 21, the second conductive layer 22 and the third conductive layer 23, the light-emitting device F located in the main display area A1 of the display panel 10 may be electrically connected to the first pixel circuit S1 in the display panel 10 through a conductive portion 211 of the first conductive layer 21 and a conductive portion 211 of the second conductive layer 22.

Alternatively, in the case where the display panel 10 includes the first conductive layer 21, the second conductive layer 22 and the third conductive layer 23, the light-emitting device F located in the main display area A1 of the display panel 10 may be electrically connected to the first pixel circuit S1 in the display panel 10 through a conductive portion 211 of the first conductive layer 21, a conductive portion 211 of the second conductive layer 22, and a conductive portion 211 of the third conductive layer 23.

For example, in the case where the display panel 10 includes the first conductive layer 21, the second conductive layer 22 and the third conductive layer 23, some of the light-emitting devices F located in the main display area A1 of the display panel 10 are electrically connected to first pixel circuits S1 in the display panel 10 through conductive portions 211 of the first conductive layer 21, some of the light-emitting devices F located in the main display area A1 of the display panel 10 are electrically connected to first pixel circuits S1 in the display panel 10 through conductive portions 211 of the first conductive layer 21 and conductive portions 211 of the second conductive layer 22, and some of the light-emitting devices F located in the main display area A1 of the display panel 10 are electrically connected to first pixel circuits S1 in the display panel 10 through conductive portions 211 of the first conductive layer 21, conductive portions 211 of the second conductive layer 22, and conductive portions 211 of the third conductive layer 23.

With continued reference to FIG. 8 and in conjunction with FIG. 7, in the case where the display panel 10 includes the first conductive layer 21, the second conductive layer 22 and the third conductive layer 23, the second pixel circuits S2 in the display panel 10 are located in the main display area A1 of the display panel 10, and the light-emitting devices F located in the secondary display area A2 of the display panel 10 are electrically connected to the corresponding second pixel circuits S2, the third conductive layer 23 in the display panel 10 can include conductive lines 212. The light-emitting device F located in the secondary display area A2 of the display panel 10 can be electrically connected to the second pixel circuit S2 in the display panel 10 through a conductive line 212 of the first conductive layer 21 and/or a conductive line 212 of the second conductive layer 22 and/or a conductive line 212 of the third conductive layer 23.

Alternatively, with continued reference to FIG. 9B, in the case where the display panel 10 includes the first conductive layer 21, the second conductive layer 22 and the third conductive layer 23, the second pixel circuits S2 in the display panel 10 are located in the secondary display area A2 of the display panel 10, and the light-emitting devices F located in the secondary display area A2 of the display panel 10 are electrically connected to the corresponding second pixel circuits S2, the third conductive layer 23 in the display panel 10 can include conductive portions 211. The light-emitting device F located in the secondary display area A2 of the display panel 10 can be electrically connected to the second pixel circuit S2 in the display panel 10 through a conductive portion 211 of the first conductive layer 21 and/or a conductive portion 211 of the second conductive layer 22 and/or a conductive portion 211 of the third conductive layer 23.

For example, a material of the third conductive layer 23 in the display panel 10 may include a transparent conductive material. For example, the material of the third conductive layer 23 in the display panel 10 includes indium tin oxide (ITO).

The material of the third conductive layer 23 in the display panel 10 includes the transparent conductive material, which may prevent the third conductive layer 23 located in the secondary display area A2 of the display panel 10 from blocking ambient light passing through the secondary display area A2 of the display panel 10, thereby allowing more ambient light to pass through the secondary display area A2 of the display panel 10, and helping to improve the light transmittance of the secondary display area A2 of the display panel 10.

In some embodiments, with continued reference to FIGS. 7, 8, 9A and 9B, the display panel 10 can further include a first planarization layer 51. The first planarization layer 51 can be located on a side of the first conductive layer 21 away from the substrate 1. The first planarization layer 51 has first through holes 511.

The first planarization layer 51 in the display panel 10 has a planarization function, which is beneficial to improving the deposition quality of subsequent materials and reducing surface differences in other film layers formed subsequently.

For example, as shown in FIG. 11, which is a sectional view of a partial region of a first planarization layer 51 in a display panel 10 in accordance with some embodiments, the first through hole 511 of the first planarization layer 51 has a first opening 511a located in a surface 51a of the first planarization layer 51 away from the substrate 1, and a second opening 511b located in a surface 51b of the first planarization layer 51 close to the substrate 1. An area of the first opening 511a of the first through hole 511 is greater than an area of the second opening 511b.

Since the area of the first opening 511a of the first through hole 511 of the first planarization layer 51 is larger than the area of the second opening 511b, the first through hole 511 of the first planarization layer 51 is a tapered hole.

With continued reference to FIG. 11, in the case where the first through hole 511 of the first planarization layer 51 is the tapered hole, a sidewall 511c of the first through hole 511 of the first planarization layer 51 is an inclined surface.

For example, a material of the first planarization layer 51 in the display panel 10 includes silicon dioxide (SiO₂), silicon nitride (Si₃N₄), aluminum oxide (Al₂O₃), an organosilicon compound, or the like.

In some embodiments, with continued reference to FIGS. 7, 8, 9A and 9B, the display panel 10 can further include a first electrode layer 4. The first electrode layer 4 is located on a side, away from the substrate 1, of the first planarization layer 51 in the display panel 10. The first electrode layer 4 includes first electrodes 41 of the light-emitting devices F.

With continued reference to FIGS. 7 and 9A, the first electrode 41 located in the main display area A1 of the display panel 10 passes through a first through hole 511 of the first planarization layer 51 and is electrically connected to the first conductive layer 21, so that the light-emitting device F located in the main display area A1 of the display panel 10 can be electrically connected to the first pixel circuit S1 in the display panel 10 through the first conductive layer 21.

With continued reference to FIGS. 8 and 9B, the first electrode 41 located in the secondary display area A2 of the display panel 10 passes through a first through hole 511 of the first planarization layer 51 and is electrically connected to the first conductive layer 21, so that the light-emitting device F located in the secondary display area A2 of the display panel 10 can be electrically connected to the second pixel circuit S2 in the display panel 10 through the first conductive layer 21.

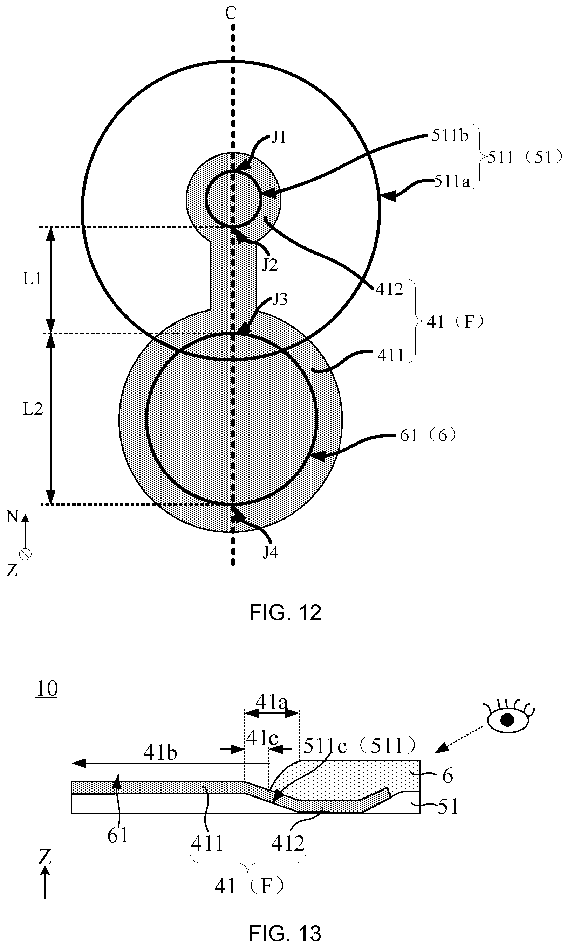

For example, as shown in FIG. 12, which is a planar structural diagram of a first through hole 511 of a first planarization layer 51, a pixel opening 61 of a pixel definition layer 6, and a first electrode 41 of a light-emitting device F in accordance with some embodiments, the first electrode 41 of the light-emitting device F (e.g., the first color light-emitting device F1, second color light-emitting device F2, and third color light-emitting device F3) can include a main body portion 411 and a connection portion 412 electrically connected to the main body portion 411.

With continued reference to FIGS. 7 and 9A as well as in conjunction with FIG. 12, in the case where the first electrode 41 of the light-emitting device F (e.g., the first color light-emitting device F1, second color light-emitting device F2, and third color light-emitting device F3) includes the main body portion 411 and the connection portion 412, the above-mentioned "the first electrode 41 located in the main display area A1 of the display panel 10 passes through a first through hole 511 of the first planarization layer 51 and is electrically connected to the first conductive layer 21" can specifically be that the connection portion 412 of the first electrode 41 located in the main display area A1 of the display panel 10 passes through the first through hole 511 of the first planarization layer 51 and is electrically connected to the first conductive layer 21.

With continued reference to FIGS. 8 and 9B as well as in conjunction with FIG. 12, in the case where the first electrode 41 of the light-emitting device F (e.g., the first color light-emitting device F1, second color light-emitting device F2, and third color light-emitting device F3) includes the main body portion 411 and the connection portion 412, the above-mentioned "the first electrode 41 located in the secondary display area A2 of the display panel 10 passes through a first through hole 511 of the first planarization layer 51 and is electrically connected to the first conductive layer 21" can specifically be that the connection portion 412 of the first electrode 41 located in the secondary display area A2 of the display panel 10 passes through the first through hole 511 of the first planarization layer 51 and is electrically connected to the first conductive layer 21.

In some embodiments, with continued reference to FIGS. 7, 8, 9A and 9B, the display panel 10 can further include a pixel definition layer 6. The pixel definition layer 6 is located on a side of the first electrode layer 4 in the display panel 10 away from the substrate 1. The pixel definition layer 6 has pixel openings 61.

With continued reference to FIGS. 7, 8, 9A and 9B as well as in conjunction with FIG. 12, in the case where the first electrode 41 of the light-emitting device F (e.g., the first color light-emitting device F1, second color light-emitting device F2, and third color light-emitting device F3) includes the main body portion 411 and the connection portion 412, the main body portion 411 of the first electrode 41 overlaps with the pixel opening 61 of the pixel definition layer 6 in the third direction Z (i.e., the thickness direction of the display panel 10).

The main body portion 411 of the first electrode 41 overlaps with the pixel opening 61 of the pixel definition layer 6 in the third direction Z (i.e., the thickness direction of the display panel 10), so that the pixel opening 61 of the pixel definition layer 6 may expose at least a portion of the main body portion 411 of the first electrode 41. Thus, the pixel definition layer 6 may effectively define an actual effective region of the first electrode 41 (i.e., a region of the main body portion 411 of the first electrode 41 that overlaps with the pixel opening 61 of the pixel definition layer 6 in the third direction Z). As a result, the pixel definition layer 6 may define a light-emitting region and a light-emitting area of the light-emitting device F (e.g., the first color light-emitting device F1, second color light-emitting device F2, and third color light-emitting device F3).

For example, with continued reference to FIG. 12, a boundary of an orthographic projection, on the substrate 1 in the display panel 10, of the main body portion 411 of the first electrode 41 of the light-emitting device F is located outside a boundary of an orthographic projection, on the substrate 1 in the display panel 10, of the pixel opening 61 of the pixel definition layer 6. That is, the orthographic projection, on the substrate 1 in the display panel 10, of the pixel opening 61 of the pixel definition layer 6 can be located within the boundary of the orthographic projection, on the substrate 1 in the display panel 10, of the main body portion 411 of the first electrode 41.

For example, a material of the pixel definition layer 6 in the display panel 10 may include an inorganic insulating material. For example, the material of the pixel definition layer 6 in the display panel 10 includes polyimide, acrylic, or polyethylene terephthalate.

For example, as shown in FIG. 13 (which is a sectional view of partial regions of a first planarization layer 51, a pixel definition layer 6 and a first electrode 41 of a light-emitting device F that are in a display panel 10, in accordance with some embodiments) and in conjunction with FIGS. 7, 8, 9A, 9B and 11, the first electrode 41 located in the main display area A1 of the display panel 10 passes through a first through hole 511 of the first planarization layer 51 and is electrically connected to the first conductive layer 21, so that the light-emitting device F located in the main display area A1 of the display panel 10 can be electrically connected to the first pixel circuit S1 in the display panel 10 through the first conductive layer 21; the first electrode 41 located in the secondary display area A2 of the display panel 10 passes through a first through hole 511 of the first planarization layer 51 and is electrically connected to the first conductive layer 21, so that the light-emitting device F located in the secondary display area A2 of the display panel 10 can be electrically connected to the second pixel circuit S2 in the display panel 10 through the first conductive layer 21; the first through hole 511 of the first planarization layer 51 is a tapered hole, and the sidewall 511c of the first through hole 511 is an inclined surface. In this case, a portion of the first electrode 41 of the light-emitting device F that covers the sidewall 511c of the first through hole 511 of the first planarization layer 51 (which is hereinafter referred to as a first portion 41a of the first electrode 41 for ease of description) is also inclined.

In the main body portion 411 of the first electrode 41 of the light-emitting device F, a portion (which is hereinafter referred to as an effective light-emitting portion 41b of the first electrode 41 for ease of description) that overlaps with the pixel opening 61 of the pixel definition layer 6 in the third direction Z (i.e., the thickness direction of the display panel 10) has an overlapping region 41c with the first portion 41a of the first electrode 41. That is, a partial region of the first electrode 41 of the light-emitting device F belongs to both the first portion 41a of the first electrode 41 and the effective light-emitting portion 41b of the first electrode 41.

For example, with continued reference to FIG. 12, a straight line passing through the center of the first through hole 511 of the first planarization layer 51 and along a preset direction N is a reference line C. The preset direction N is a direction in which the main body portion 411 and the connection portion 412 of the first electrode 41 of the light-emitting device F are connected.

In orthographic projections on the substrate 1 in the display panel 10, the boundary of the first through hole 511 of the first planarization layer 51 (i.e., a boundary of the second opening 511b of the first through hole 511) intersects the reference line C at a first intersection point J1 and a second intersection point J2. The first intersection point J1 is farther away from the pixel opening 61 of the pixel definition layer 6 than the second intersection point J2. The boundary of the pixel opening 61 of the pixel definition layer 6 intersects the reference line C at a third intersection point J3 and a fourth intersection point J4. The third intersection point J3 is closer to the first through hole 511 of the first planarization layer 51 than the fourth intersection point J4. A distance between the second intersection point J2 and the third intersection point J3 is a first length L1, and a distance between the third intersection point J3 and the fourth intersection point J4 is a second length L2.

It can be understood that the first length L1 corresponding to the light-emitting device F of the display panel 10 is the minimum distance on the reference line C between the boundary of the orthographic projection, on the substrate 1 in the display panel 10, of the first through hole 511 corresponding to the light-emitting device F in the display panel 10 (i.e., the boundary of the orthographic projection of the second opening 511b of the first through hole 511) and the boundary of the orthographic projection, on the substrate 1 in the display panel 10, of the pixel opening 61 of the pixel definition layer 6 corresponding to the same light-emitting device F.

The second length L2 corresponding to the light-emitting device F in the display panel 10 is a length, on the reference line C, of the orthographic projection, on the substrate 1 in the display panel 10, of the pixel opening 61 of the pixel definition layer 6 corresponding to the light-emitting device F in the display panel 10.

For example, with continued reference to FIGS. 4 and 12, in the case where the plurality of light-emitting devices F in the display area AA of the display panel 10 emit light of different colors, the second length L2 corresponding to the first color light-emitting device F1 in the display panel 10 is less than the second length L2 corresponding to other color light-emitting devices F (e.g., the second color light-emitting device F2 and the third color light-emitting device F3) in the display panel 10. That is, among the plurality of light-emitting devices F in the display area AA of the display panel 10, the second length L2 corresponding to the first color light-emitting device F1 is the smallest.

For example, in the case where the light-emitting devices F in the main display area A1 of the display panel 10 include first color light-emitting devices F1, second color light-emitting devices F2 and third color light-emitting devices F3, the second length L2 corresponding to the first color light-emitting device F1 in the main display area A1 of the display panel 10 is less than the second length L2 corresponding to the second color light-emitting device F2 in the main display area A1 of the display panel 10, and the second length L2 corresponding to the second color light-emitting device F2 in the main display area A1 of the display panel 10 is less than the second length L2 corresponding to the third color light-emitting device F3 in the main display area A1 of the display panel 10.

For another example, in the case where the light-emitting devices F in the secondary display area A2 of the display panel 10 include first color light-emitting devices F1, second color light-emitting devices F2 and third color light-emitting devices F3, the second length L2 corresponding to the first color light-emitting device F1 in the secondary display area A2 of the display panel 10 is less than the second length L2 corresponding to the second color light-emitting device F2 in the secondary display area A2 of the display panel 10, and the second length L2 corresponding to the second color light-emitting device F2 in the secondary display area A2 of the display panel 10 is less than the second length L2 corresponding to the third color light-emitting device F3 in the secondary display area A2 of the display panel 10.

In some embodiments, with continued reference to FIGS. 7, 8, 9A and 9B, the light-emitting portion 43 of the light-emitting device F (e.g., the first color light-emitting device F1, second color light-emitting device F2, and third color light-emitting device F3) can be located in the pixel opening 61 of the pixel definition layer 6 and electrically connected to the first electrode 41 of the first electrode layer 4.

For example, with continued reference to FIGS. 7, 8, 9A and 9B, in the case where the first electrode 41 of the first electrode layer 4 includes the main body portion 411 and the connection portion 412, the light-emitting portion 43 of the light-emitting device F is electrically connected to the main body portion 411 of the first electrode 41.

In some embodiments, with continued reference to FIGS. 7, 8, 9A and 9B, the second electrode 42 of the light-emitting device F (e.g., the first color light-emitting device F1, second color light-emitting device F2, and third color light-emitting device F3) can be located on a side of the pixel definition layer 6 in the display panel 10 away from the substrate 1.

In some embodiments, with continued reference to FIGS. 7, 8, 9A and 9B, the display panel 10 can further include an encapsulation structure 7. The encapsulation structure 7 is located on a side of the second electrodes 42 of the light-emitting devices F away from the substrate 1. The encapsulation structure 7 is used to encapsulate the light-emitting devices F to protect the light-emitting devices F, thereby avoiding corrosion caused by external moisture and oxygen.

For example, the encapsulation structure 7 in the display panel 10 includes an inorganic encapsulation layer and an organic encapsulation layer. A material of the inorganic encapsulation layer includes an inorganic material, which can be used to block water and oxygen. A material of the organic encapsulation layer includes an organic material, which can function to planarize the interface, cover defects and release stress.

In some embodiments, with continued reference to FIG. 4 and in conjunction with FIGS. 7, 8, 9A and 9B, in the case where the light transmittance of the main display area A1 of the display panel 10 is less than the light transmittance of the secondary display area A2, an effective light-emitting area of a single light-emitting device F located in the main display area A1 of the display panel 10 is greater than an effective light-emitting area of a single light-emitting device F, which has the same color as the light-emitting device F located in the main display area A1 of the display panel 10, located in the secondary display area A2 of the display panel 10.

For example, with continued reference to FIGS. 7, 8, 9A and 9B, in the case where the display panel 10 includes the first color light-emitting devices F1, the second color light-emitting devices F2 and the third color light-emitting devices F3, an effective light-emitting area of the first color light-emitting device F1 located in the main display area A1 of the display panel 10 can be greater than an effective light-emitting area of the first color light-emitting device F1 located in the secondary display area A2 of the display panel 10.

An effective light-emitting area of the second color light-emitting device F2 located in the main display area A1 of the display panel 10 can be greater than an effective light-emitting area of the second color light-emitting device F2 located in the secondary display area A2 of the display panel 10.

An effective light-emitting area of the third color light-emitting device F3 located in the main display area A1 of the display panel 10 can be greater than an effective light-emitting area of the third color light-emitting device F3 located in the secondary display area A2 of the display panel 10.

It should be noted that, with continued reference to FIGS. 7, 8, 9A and 9B as well as in conjunction with FIG. 11, the above-mentioned "effective light-emitting area of the light-emitting device F" refers to an area of a region of the light-emitting device F that actually participates in light emission and generates visible light. In general, the region of the light-emitting device F that actually participates in light emission and generates visible light is a region where the main body portion 411 of the first electrode 41 of the light-emitting device F overlaps with the pixel opening 61 of the pixel definition layer 6 in the third direction Z (i.e., the thickness direction of the display panel 10).

In other words, in general, the effective light-emitting area of the light-emitting device F refers to an area of the region where the main body portion 411 of the first electrode 41 of the light-emitting device F overlaps with the pixel opening 61 of the pixel definition layer 6 in the third direction Z (i.e., the thickness direction of the display panel 10).

The effective light-emitting area of a single light-emitting device F located in the main display area A1 of the display panel 10 is greater than the effective light-emitting area of a single light-emitting device F located in the secondary display area A2 of the display panel 10 that has the same color as the light-emitting device F located in the main display area A1 of the display panel 10, so that an area of a region where the main body portion 411 of the first electrode 41 of the light-emitting device F located in the main display area A1 of the display panel 10 overlaps with the pixel opening 61 of the pixel definition layer 6 in the third direction Z (i.e., the thickness direction of the display panel 10) is greater than an area of a region where the main body portion 411 of the first electrode 41 of the light-emitting device F, which has the same color as the light-emitting device F located in the main display area A1 of the display panel 10, located in the secondary display area A2 of the display panel 10 overlaps with the pixel opening 61 of the pixel definition layer 6 in the third direction Z (i.e., the thickness direction of the display panel 10). This makes it possible for an area of the first electrode 41 of a single light-emitting device F located in the main display area A1 of the display panel 10 to be greater than an area of the first electrode 41 of a single light-emitting device F, which has the same color as the light-emitting device F located in the main display area A1 of the display panel 10, located in the secondary display area A2 of the display panel 10. That is, the area of the first electrode 41 of the light-emitting device F located in the secondary display area A2 of the display panel 10 is relatively small. An area ratio of an orthographic projection, on the substrate 1 in the display panel 10, of the first electrode 41 of the light-emitting device F in the secondary display area A2 of the display panel 10 may be reduced, which may reduce the obstruction of ambient light passing through the secondary display area A2 of the display panel 10, and be beneficial to improving the light transmittance of the secondary display area A2 of the display panel 10. Thus, the light transmittance of the main display area A1 of the display panel 10 is less than the light transmittance of the secondary display area A2.

The effective light-emitting area of a single light-emitting device F located in the main display area A1 of the display panel 10 is greater than the effective light-emitting area of a single light-emitting device F located in the secondary display area A2 of the display panel 10 that has the same color as the light-emitting device F located in the main display area A1 of the display panel 10, so that the light transmittance of the main display area A1 of the display panel 10 is less than the light transmittance of the secondary display area A2. In this case, the number of light-emitting devices F per unit area within the secondary display area A2 of the display panel 10 can be the same as or similar to the number of light-emitting devices F per unit area within the main display area A1 of the display panel 10. That is, the pixel density (pixels per inch, PPI) of the secondary display area A2 of the display panel 10 can be the same as or similar to the pixel density (pixels per inch, PPI) of the main display area A1 of the display panel 10. This may reduce the probability of mura (i.e., uneven brightness when the display panel 10 displays an image) of the display panel 10, which is beneficial to improving the display uniformity of the display panel 10 when displaying an image, and in turn improves the display effect of the display panel 10.

With continued reference to FIG. 4 and in conjunction with FIGS. 8, 9B and 13, in a case where the effective light-emitting area of a single light-emitting device F located in the main display area A1 of the display panel 10 is greater than the effective light-emitting area of a single light-emitting device F located in the secondary display area A2 of the display panel 10 that has the same color as the light-emitting device F located in the main display area A1 of the display panel 10, and there is an overlapping region 41c between the effective light-emitting portion 41b of the first electrode 41 of the light-emitting device F and the first portion 41a of the first electrode 41, since the first portion 41a of the first electrode 41 of the light-emitting device F is arranged to be inclined, the overlapping region 41c between the effective light-emitting portion 41b of the first electrode 41 and the first portion 41a of the first electrode 41 is also inclined. As a result, the overlapping region 41c between the effective light-emitting portion 41b of the first electrode 41 and the first portion 41a of the first electrode 41 easily leads to a decrease in flatness of the effective light-emitting portion 41b of the first electrode 41.

Since the effective light-emitting area of the light-emitting device F located in the secondary display area A2 of the display panel 10 is relatively small, the area of the effective light-emitting portion 41b of the first electrode 41 of the light-emitting device F located in the secondary display area A2 of the display panel 10 is also small. Thus, in the effective light-emitting portion 41b of the first electrode 41 of the light-emitting device F located in the secondary display area A2 of the display panel 10, the overlapping region 41c between the effective light-emitting portion 41b of the first electrode 41 and the first portion 41a of the first electrode 41 occupies a relatively large space, which easily leads to the low flatness of the effective light-emitting portion 41b of the first electrode 41 of the light-emitting device F located in the secondary display area A2 of the display panel 10, and in turn easily leads to a reduction in the light emission symmetry of the light-emitting device F located in the secondary display area A2 of the display panel 10. When the human eyes view the display panel 10 at an oblique viewing angle, there may be a color difference between the main display area A1 and the secondary display area A2 of the display panel 10 (for example, an image displayed in the secondary display area A2 of the display panel 10 may appear reddish, greenish, or purplish), which easily leads to a reduction in the display uniformity of the display panel 10, and in turn easily leads to a reduction in the display effect of the display panel 10.

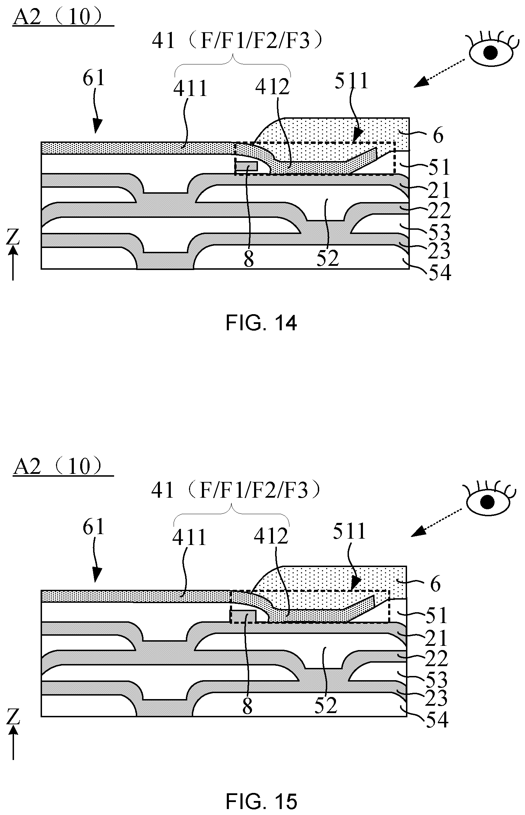

Based on this, in order to reduce the probability of color difference between the main display area A1 and the secondary display area A2 of the display panel 10 (for example, the probability that the image displayed in the secondary display area A2 of the display panel 10 appears reddish, greenish, or purplish) when the human eyes view the display panel 10 at an oblique viewing angle, improve the display uniformity of the display panel 10, and enhance the display effect of the display panel 10, Embodiment 1 to Embodiment 6 of the present disclosure will be described below in conjunction with FIGS. 14 to 37.

Embodiment 1 of the present disclosure will be described in detail below.

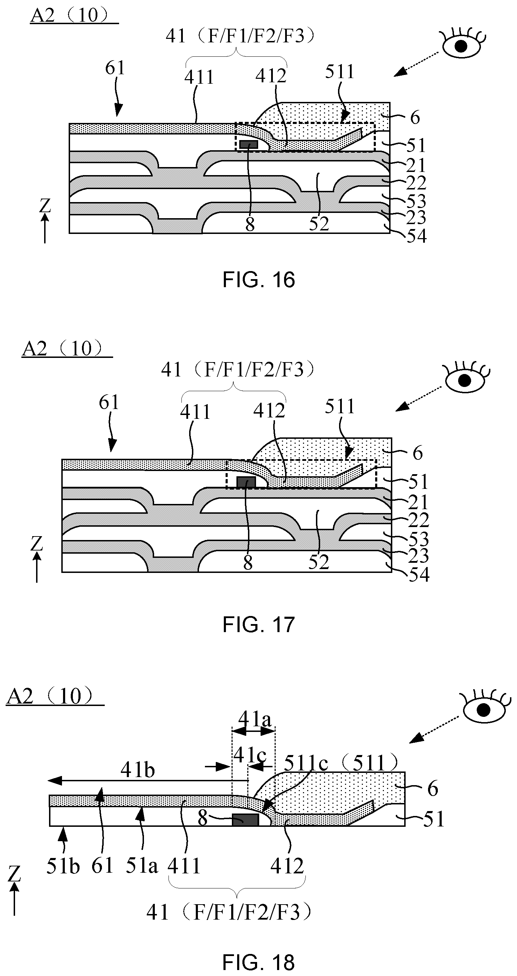

Embodiment 1: as shown in FIGS. 14, 15, 16, 17 and 18 (where FIGS. 14, 15, 16 and 17 are each a film-layer structural diagram of a partial region of a secondary display area A2 of a display panel 10 in accordance with some embodiments, and FIG. 18 is a sectional view of partial regions of a first planarization layer 51, a pixel definition layer 6 and a first electrode 41 of a light-emitting device F that are in a display panel 10 in accordance with some embodiments), the display panel 10 can further include support portions 8. The support portion 8 is located in the secondary display area A2 of the display panel 10, and the first planarization layer 51 in the display panel 10 covers the support portion 8. The support portion 8 is close to the first through hole 511 of the first planarization layer 51, and is located on a side of the first through hole 511 of the first planarization layer 51 close to the center of the first electrode 41 of the light-emitting device F. A material of the support portion 8 is different from the material of the first planarization layer 51.

The support portion 8 is arranged in the secondary display area A2 of the display panel 10, and the first planarization layer 51 in the display panel 10 covers the support portion 8; the support portion 8 is close to the first through hole 511 of the first planarization layer 51, and is located on the side of the first through hole 511 of the first planarization layer 51 close to the center of the first electrode 41 of the light-emitting device F (that is, the support portion 8 is located on the side of the first through hole 511 of the first planarization layer 51 close to the effective light-emitting portion 41b of the first electrode 41 of the light-emitting device F). Thus, the support portion 8 may serve to support a sidewall 511c, close to the effective light-emitting portion 41b of the first electrode 41 of the light-emitting device F, of the first through hole 511 of the first planarization layer 51. As a result, in a section of the display panel 10 parallel to the third direction Z (i.e., the thickness direction of the display panel 10), the sidewall 511c of the first through hole 511 close to the effective light-emitting portion 41b of the first electrode 41 is arc-shaped and protrudes towards the interior of the first through hole 511. Moreover, it is possible to improve the flatness of a partial region, adjacent to the surface 51a of the first planarization layer 51 away from the substrate 1, in the sidewall 511c of the first through hole 511 close to the effective light-emitting portion 41b of the first electrode 41, and in turn improve the flatness of a portion of the first electrode 41 (i.e., the first portion 41a of the first electrode 41) covering the sidewall 511c of the first through hole 511 close to the effective light-emitting portion 41b of the first electrode 41. In this way, the flatness of the overlapping region 41c between the effective light-emitting portion 41b and the first portion 41a of the first electrode 41 is relatively high, thereby improving the flatness of the effective light-emitting portion 41b of the first electrode 41 and helping to improve the light emission symmetry of the light-emitting device F located in the secondary display area A2 of the display panel 10. When the human eyes view the display panel 10 at an oblique viewing angle, it is possible to reduce the probability of color difference between the main display area A1 and the secondary display area A2 of the display panel 10 (for example, the probability that the image displayed in the secondary display area A2 of the display panel 10 appears reddish, greenish, or purplish), which is beneficial to improving the display uniformity of the display panel 10 and the display effect of the display panel 10.

For example, with continued reference to FIGS. 14 and 16, the support portion 8 in the display panel 10 is embedded in the first planarization layer 51; and in the third direction Z (i.e., the thickness direction of the display panel 10), there is a gap between the support portion 8 and the first conductive layer 21 in the display panel 10, and between the support portion 8 and the first electrode 41 of the light-emitting device F. That is, in the third direction Z (i.e., the thickness direction of the display panel 10), the support portion 8 is not in contact with both the first conductive layer 21 in the display panel 10 and the first electrode 41 of the light-emitting device F.

Alternatively, with continued reference to FIGS. 15 and 17, the support portion 8 in the display panel 10 can be in contact with the first conductive layer 21.

For example, a material of the support portion 8 in the display panel 10 may include at least one of metal and metal oxide.

For example, the material of the support portion 8 in the display panel 10 includes one or more of nickel (Ni), copper (Cu), aluminum (Al), tungsten (W), molybdenum (Mo), and other metal materials.

For another example, the material of the support portion 8 in the display panel 10 includes one or more of indium tin oxide (ITO) and other metal oxide materials.

For another example, the material of the support portion 8 in the display panel 10 includes one or more of nickel (Ni), copper (Cu), aluminum (Al), tungsten (W), molybdenum (Mo) and other metal materials, as well as one or more of indium tin oxide (ITO) and other metal oxide materials.

For example, with continued reference to FIGS. 15 and 17, the material of the support portion 8 in the display panel 10 can be the same as the material of the first conductive layer 21. For example, the materials of the support portion 8 and the first conductive layer 21 in the display panel 10 both include indium tin oxide (ITO).

With continued reference to FIGS. 15 and 17, in the case where the material of the support portion 8 in the display panel 10 is the same as that of the first conductive layer 21, and the support portion 8 is in contact with the first conductive layer 21, the support portion 8 and the first conductive layer 21 in the display panel 10 can be in an integral structure. That is, there is no obvious connection interface between the support portion 8 and the first conductive layer 21 in the display panel 10.

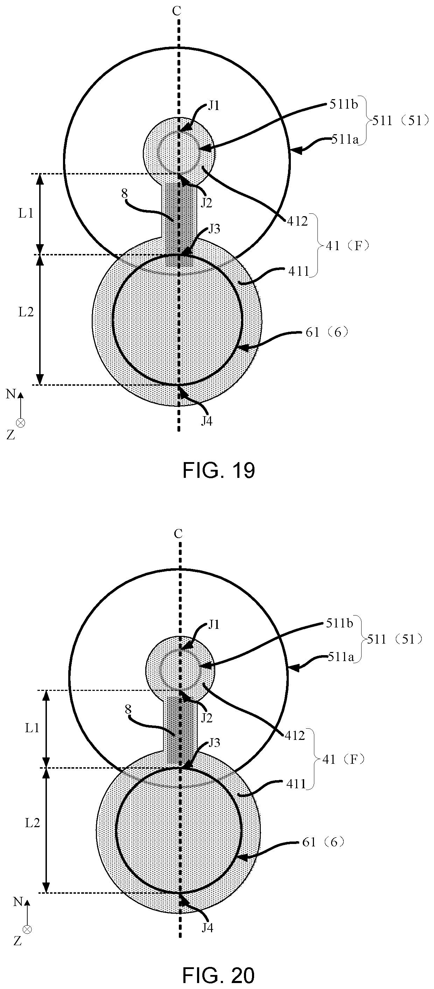

For example, as shown in FIGS. 19 and 20 (which are each a planar structural diagram of a support portion 8, a first through hole 511, a pixel opening 61, and a first electrode 41 of a light-emitting device F that are in a display panel 10, in accordance with some embodiments), and in conjunction with FIGS. 14, 15, 16, 17 and 18, the support portion 8 in the display panel 10 can surround at least a portion of the first through hole 511.

For example, with continued reference to FIGS. 19 and 20, the support portion 8 in the display panel 10 is arranged around a portion of the first through hole 511.

For another example, the support portion 8 in the display panel 10 is arranged around the entire first through hole 511.

For example, with continued reference to FIGS. 19 and 20, in the case where the support portion 8 in the display panel 10 is arranged around a portion of the first through hole 511, an orthographic projection of the support portion 8 on the substrate 1 in the display panel 10 can be located within a boundary of an orthographic projection of the first electrode 41 of the light-emitting device F on the substrate 1 in the display panel 10.

In the case where the material of the support portion 8 in the display panel 10 includes metal, the orthographic projection of the support portion 8 on the substrate 1 in the display panel 10 is located within the boundary of the orthographic projection of the first electrode 41 of the light-emitting device F on the substrate 1 in the display panel 10, so that in orthographic projections on the substrate 1 in the display panel 10, a total area of the support portion 8 in the display panel 10 and the first electrode 41 of the light-emitting device F may be equal to an area of the first electrode 41 of the light-emitting device F. This avoids increasing an area ratio of the light-shielding metal in the secondary display area A2 of the display panel 10 when the support portion 8 is provided in the secondary display area A2 of the display panel 10, helps to reduce the obstruction of ambient light passing through the secondary display area A2 of the display panel 10, and thereby helps to improve the light transmittance of the secondary display area A2 of the display panel 10.

For example, with continued reference to FIG. 19 and in conjunction with FIG. 18, in the case where the first through hole 511 of the first planarization layer 51 has the first opening 511a located in the surface 51a of the first planarization layer 51 away from the substrate 1 and the second opening 511b located in the surface 51b of the first planarization layer 51 close to the substrate 1, and the area of the first opening 511a of the first through hole 511 is greater than the area of the second opening 511b, in orthographic projections on the substrate 1 in the display panel 10, at least a portion of the support portion 8 in the display panel 10 can be located between boundaries of the first opening 511a and the second opening 511b of the first through hole 511.

In orthographic projections on the substrate 1 in the display panel 10, at least a portion of the support portion 8 in the display panel 10 is located between the first opening 511a and the second opening 511b of the first through hole 511, so that a distance between the support portion 8 in the display panel 10 and the sidewall 511c of the first through hole 511 close to the effective light-emitting portion 41b of the first electrode 41 of the light-emitting device F may be relatively small, which is beneficial to enhancing the supporting effect of the support portion 8 on the sidewall 511c of the first through hole 511 close to the effective light-emitting portion 41b of the first electrode 41 of the light-emitting device F. As a result, in a section of the display panel 10 parallel to the third direction Z (i.e., the thickness direction of the display panel 10), the sidewall 511c of the first through hole 511 close to the effective light-emitting portion 41b of the first electrode 41 is arc-shaped and protrudes towards the interior of the first through hole 511. Moreover, it is possible to further improve the flatness of a partial region, adjacent to the surface 51a of the first planarization layer 51 away from the substrate 1, in the sidewall 511c of the first through hole 511 close to the effective light-emitting portion 41b of the first electrode 41, and in turn improve the flatness of a portion of the first electrode 41 (i.e., the first portion 41a of the first electrode 41) covering the sidewall 511c of the first through hole 511 close to the effective light-emitting portion 41b of the first electrode 41. In this way, the flatness of the overlapping region 41c between the effective light-emitting portion 41b and the first portion 41a of the first electrode 41 is further improved, thereby further improving the flatness of the effective light-emitting portion 41b of the first electrode 41 and helping to improve the light emission symmetry of the light-emitting device F located in the secondary display area A2 of the display panel 10. When the human eyes view the display panel 10 at an oblique viewing angle, it is possible to further reduce the probability of color difference between the main display area A1 and the secondary display area A2 of the display panel 10 (for example, the probability that the image displayed in the secondary display area A2 of the display panel 10 appears reddish, greenish, or purplish), which is beneficial to further improving the display uniformity of the display panel 10 and the display effect of the display panel 10.

For example, with continued reference to FIG. 20 and in conjunction with FIG. 18, in the case where the first through hole 511 of the first planarization layer 51 has the first opening 511a located in the surface 51a of the first planarization layer 51 away from the substrate 1 and the second opening 511b located in the surface 51b of the first planarization layer 51 close to the substrate 1, the area of the first opening 511a of the first through hole 511 is greater than the area of the second opening 511b, and the first electrode 41 (e.g., the main body portion 411 of the first electrode 41) of the light-emitting device F overlaps with the pixel opening 61 of the pixel definition layer 6 in the third direction Z (i.e., the thickness direction of the display panel 10), in orthographic projections on the substrate 1 in the display panel 10, at least a portion of the support portion 8 in the display panel 10 can be located between boundaries of the second opening 511b of the first through hole 511 and the pixel opening 61 of the pixel definition layer 6.

In orthographic projections on the substrate 1 in the display panel 10, at least a portion of the support portion 8 in the display panel 10 is located between the boundary of the second opening 511b of the first through hole 511 and the boundary of the pixel opening 61 of the pixel definition layer 6, so that the distance between the support portion 8 in the display panel 10 and the sidewall 511c of the first through hole 511 close to the effective light-emitting portion 41b of the first electrode 41 of the light-emitting device F may be further reduced, which is beneficial to further enhancing the supporting effect of the support portion 8 on the sidewall 511c of the first through hole 511 close to the effective light-emitting portion 41b of the first electrode 41 of the light-emitting device F. As a result, in a section of the display panel 10 parallel to the third direction Z (i.e., the thickness direction of the display panel 10), the sidewall 511c of the first through hole 511 close to the effective light-emitting portion 41b of the first electrode 41 is arc-shaped and further protrudes towards the interior of the first through hole 511. Moreover, it is possible to further improve the flatness of a partial region, adjacent to the surface 51a of the first planarization layer 51 away from the substrate 1, in the sidewall 511c of the first through hole 511 close to the effective light-emitting portion 41b of the first electrode 41, and in turn improve the flatness of a portion of the first electrode 41 (i.e., the first portion 41a of the first electrode 41) covering the sidewall 511c of the first through hole 511 close to the effective light-emitting portion 41b of the first electrode 41. In this way, the flatness of the overlapping region 41c between the effective light-emitting portion 41b and the first portion 41a of the first electrode 41 is further improved, thereby further improving the flatness of the effective light-emitting portion 41b of the first electrode 41 and helping to improve the light emission symmetry of the light-emitting device F located in the secondary display area A2 of the display panel 10. When the human eyes view the display panel 10 at an oblique viewing angle, it is possible to further reduce the probability of color difference between the main display area A1 and the secondary display area A2 of the display panel 10 (for example, the probability that the image displayed in the secondary display area A2 of the display panel 10 appears reddish, greenish, or purplish), which is beneficial to further improving the display uniformity of the display panel 10 and the display effect of the display panel 10.

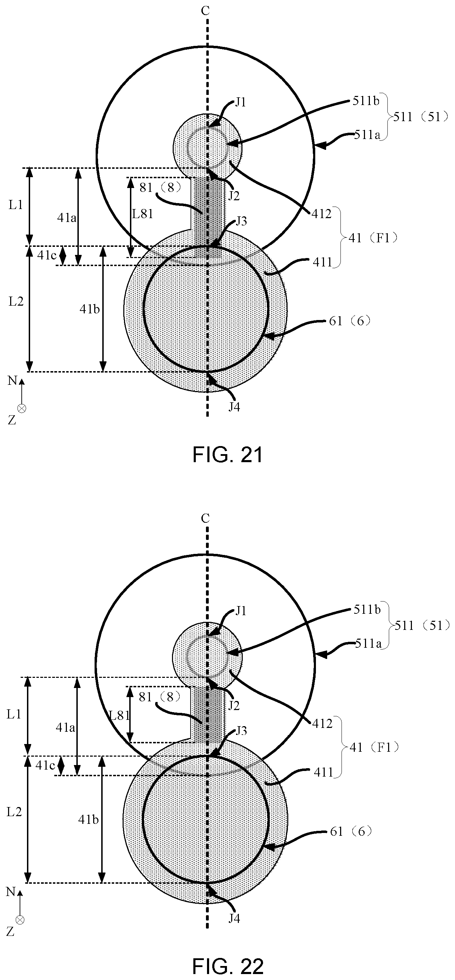

For example, as shown in FIGS. 21 and 22 (which are each a planar structural diagram of a first support portion 81, a first through hole 511, a pixel opening 61, and a first electrode 41 of a first color light-emitting device F1 that are in a display panel 10, in accordance with some embodiments), and in conjunction with FIGS. 4 and 18, it should be noted that the difference between FIGS. 21 and 22 is that, in FIG. 21, in orthographic projections on the substrate 1 in the display panel 10, at least a portion of the support portion 8 in the display panel 10 is located between the boundaries of the first opening 511a and the second opening 511b of the first through hole 511, and in FIG. 22, in orthographic projections on the substrate 1 in the display panel 10, at least a portion of the support portion 8 in the display panel 10 is located between the boundaries of the second opening 511b of the first through hole 511 and the pixel opening 61 of the pixel definition layer 6.

In the case where the display panel 10 includes the first color light-emitting devices F1, and the second length L2 corresponding to the first color light-emitting device F1 is less than the second length L2 corresponding to other color light-emitting devices F (e.g., the second color light-emitting device F2 and the third color light-emitting device F3) in the display panel 10, the support portions 8 in the display panel 10 include first support portions 81. The first support portion 81 is close to the first through hole 511 corresponding to the first electrode 41 of the first color light-emitting device F1.

The second length L2 corresponding to the first color light-emitting device F1 in the display panel 10 is less than the second length L2 corresponding to other color light-emitting devices F (e.g., the second color light-emitting device F2 and the third color light-emitting device F3) in the display panel 10 (that is, a length, on the reference line C, of an orthographic projection of the pixel opening 61 of the pixel definition layer 6 corresponding to the first color light-emitting device F1 in the display panel 10 on the substrate 1 in the display panel 10 is relatively small); and therefore, on the reference line C, the overlapping region 41c between the effective light-emitting portion 41b and the first portion 41a of the first electrode 41 of the first color light-emitting device F1 has a large proportion in the effective light-emitting portion 41b of the first electrode 41 of the first color light-emitting device F1. As a result, the overlapping region 41c between the effective light-emitting portion 41b and the first portion 41a of the first electrode 41 of the first color light-emitting device F1 has a relatively large influence on the flatness of the effective light-emitting portion 41b of the first electrode 41.

By arranging the first support portion 81 close to the first through hole 511 corresponding to the first electrode 41 of the first color light-emitting device F1, the first support portion 81 may serve to support the sidewall 511c of the first through hole 511 corresponding to the first electrode 41 of the first color light-emitting device F1. As a result, in a section of the display panel 10 parallel to the third direction Z (i.e., the thickness direction of the display panel 10), the sidewall 511c of the first through hole 511 close to the effective light-emitting portion 41b of the first electrode 41 of the first color light-emitting device F1 is arc-shaped and protrudes towards the interior of the first through hole 511. Moreover, it is possible to improve the flatness of a partial region, adjacent to the surface 51a of the first planarization layer 51 away from the substrate 1, in the sidewall 511c of the first through hole 511 close to the effective light-emitting portion 41b of the first electrode 41 of the first color light-emitting device F1, and in turn improve the flatness of a portion of the first electrode 41 (i.e., the first portion 41a of the first electrode 41) covering the sidewall 511c of the first through hole 511 close to the effective light-emitting portion 41b of the first electrode 41 of the first color light-emitting device F1. In this way, the flatness of the overlapping region 41c between the effective light-emitting portion 41b and the first portion 41a of the first electrode 41 is relatively high, thereby improving the flatness of the effective light-emitting portion 41b of the first electrode 41 of the first color light-emitting device F1 and helping to improve the light emission symmetry of the first light-emitting device F1 located in the secondary display area A2 of the display panel 10. When the human eyes view the display panel 10 at an oblique viewing angle, it is possible to reduce the probability of color difference between the main display area A1 and the secondary display area A2 of the display panel 10 (for example, the probability that the image displayed in the secondary display area A2 of the display panel 10 appears reddish, greenish, or purplish), which is beneficial to improving the display uniformity of the display panel 10 and the display effect of the display panel 10.

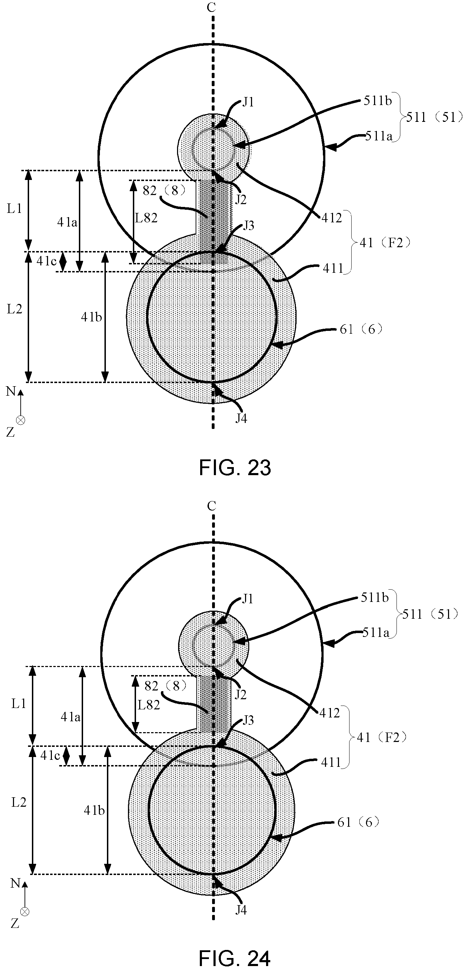

For example, as shown in FIGS. 23 and 24 (which are each a planar structural diagram of a second support portion 82, a first through hole 511, a pixel opening 61, and a first electrode 41 of a second color light-emitting device F2 that are in a display panel 10, in accordance with some embodiments), and in conjunction with FIGS. 4 and 18, it should be noted that the difference between FIGS. 23 and 24 is that, in FIG. 23, in orthographic projections on the substrate 1 in the display panel 10, at least a portion of the support portion 8 in the display panel 10 is located between the boundaries of the first opening 511a and the second opening 511b of the first through hole 511, and in FIG. 24, in orthographic projections on the substrate 1 in the display panel 10, at least a portion of the support portion 8 in the display panel 10 is located between the boundaries of the second opening 511b of the first through hole 511 and the pixel opening 61 of the pixel definition layer 6.

In the case where the display panel 10 includes the second color light-emitting devices F2, the support portions 8 in the display panel 10 include second support portions 82. The second support portion 82 is close to the first through hole 511 corresponding to the first electrode 41 of the second color light-emitting device F2.

By arranging the second support portion 82 close to the first through hole 511 corresponding to the first electrode 41 of the second color light-emitting device F2, the second support portion 82 may serve to support the sidewall 511c of the first through hole 511 corresponding to the first electrode 41 of the second color light-emitting device F2. As a result, in a section of the display panel 10 parallel to the third direction Z (i.e., the thickness direction of the display panel 10), the sidewall 511c of the first through hole 511 close to the effective light-emitting portion 41b of the first electrode 41 of the second color light-emitting device F2 is arc-shaped and protrudes towards the interior of the first through hole 511. Moreover, it is possible to improve the flatness of a partial region, adjacent to the surface 51a of the first planarization layer 51 away from the substrate 1, in the sidewall 511c of the first through hole 511 close to the effective light-emitting portion 41b of the first electrode 41 of the second color light-emitting device F2, and in turn improve the flatness of a portion of the first electrode 41 (i.e., the first portion 41a of the first electrode 41) covering the sidewall 511c of the first through hole 511 close to the effective light-emitting portion 41b of the first electrode 41 of the second color light-emitting device F2. In this way, the flatness of the overlapping region 41c between the effective light-emitting portion 41b and the first portion 41a of the first electrode 41 is relatively high, thereby improving the flatness of the effective light-emitting portion 41b of the first electrode 41 of the second color light-emitting device F2 and helping to improve the light emission symmetry of the of the second color light-emitting device F2 located in the secondary display area A2 of the display panel 10. When the human eyes view the display panel 10 at an oblique viewing angle, it is possible to reduce the probability of color difference between the main display area A1 and the secondary display area A2 of the display panel 10 (for example, the probability that the image displayed in the secondary display area A2 of the display panel 10 appears reddish, greenish, or purplish), which is beneficial to improving the display uniformity of the display panel 10 and the display effect of the display panel 10.

It should be noted that, in the case where the display panel 10 includes the third color light-emitting devices F3, a third support portion (not shown in the figure) may be provided in the display panel 10 according to actual needs, and the third support portion may be close to the first through hole 511 corresponding to the first electrode 41 of the third color light-emitting device F3, which will not be described in detail here.

With continued reference to FIGS. 21, 22, 23 and 24, and in conjunction with FIGS, 4 and 18, in a case where the display panel 10 includes the first color light-emitting device F1 and the second color light-emitting device F2, the second length L2 corresponding to the first color light-emitting device F1 is less than the second length L2 corresponding to the second color light-emitting device F2, and support portions 8 in the display panel 10 include the first support portion 81 and the second support portion 82, a dimension L81 of the first support portion 81 along an axis of the preset direction N can be greater than a dimension L82 of the second support portion 82 along the axis of the preset direction N.

The second length L2 corresponding to the first color light-emitting device F1 in the display panel 10 is less than the second length L2 corresponding to the second color light-emitting device F2 in the display panel 10 (that is, in orthographic projections on the substrate 1 in the display panel 10, the length, on the reference line C, of the pixel opening 61 of the pixel definition layer 6 corresponding to the first color light-emitting device F1 in the display panel 10 is less than the length, on the reference line C, of the pixel opening 61 of the pixel definition layer 6 corresponding to the second color light-emitting device F2); and therefore, a proportion of the overlapping region 41c between the effective light-emitting portion 41b and the first portion 41a of the first electrode 41 of the first color light-emitting device F1 in the effective light-emitting portion 41b of the first electrode 41 of the first color light-emitting device F1 is greater than a proportion of the overlapping region 41c between the effective light-emitting portion 41b and the first portion 41a of the first electrode 41 of the second color light-emitting device F2 in the effective light-emitting portion 41b of the first electrode 41 of the second color light-emitting device F2. As a result, the influence of the overlapping region 41c between the effective light-emitting portion 41b and the first portion 41a of the first electrode 41 of the first color light-emitting device F1 on the flatness of the effective light-emitting portion 41b of the first electrode 41 is greater than the influence of the overlapping region 41c between the effective light-emitting portion 41b and the first portion 41a of the first electrode 41 of the second color light-emitting device F2 on the flatness of the effective light-emitting portion 41b of the first electrode 41.

By making the dimension L81 of the first support portion 81 along the axis of the preset direction N greater than the dimension L82 of the second support portion 82 along the axis of the preset direction N, differentiated arrangement is adopted for the first support portion 81 corresponding to the first color light-emitting device F1 and the second support portion 82 corresponding to the second color light-emitting device F2. This allows the first support portion 81 corresponding to the first color light-emitting device F1, in which the overlapping region 41c between the effective light-emitting portion 41b and the first portion 41a of the first electrode 41 has a relatively large influence on the flatness of the effective light-emitting portion 41b of the first electrode 41, to have a large dimension L81 along the axis of the preset direction N, and allows the second support portion 82 corresponding to the second color light-emitting device F2, in which the overlapping region 41c between the effective light-emitting portion 41b and the first portion 41a of the first electrode 41 has a relatively small influence on the flatness of the effective light-emitting portion 41b of the first electrode 41, to have a small dimension L82 along the axis of the preset direction N. As a result, it is possible to simultaneously improve the flatness of the effective light-emitting portions 41b of the first electrodes 41 of the first color light-emitting device F1 and the second color light-emitting device F2, and is beneficial to improve the light emission symmetry of the first color light-emitting device F1 and the second color light-emitting device F2 located in the secondary display area A2 of the display panel 10. When the human eyes view the display panel 10 at an oblique viewing angle, it is possible to further reduce the probability of color difference between the main display area A1 and the secondary display area A2 of the display panel 10 (for example, the probability that the image displayed in the secondary display area A2 of the display panel 10 appears reddish, greenish, or purplish), which is beneficial to further improving the display uniformity of the display panel 10 and the display effect of the display panel 10.

Embodiment 2 of the present disclosure will be described in detail below.

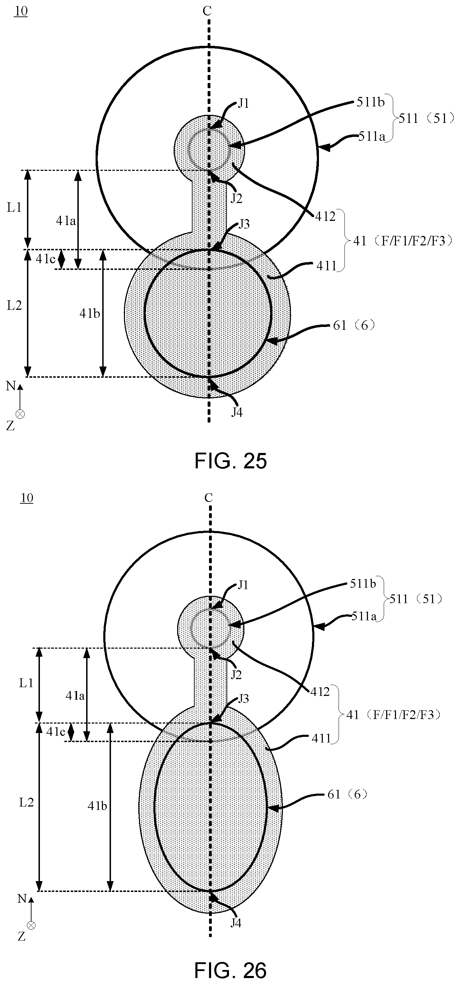

Embodiment 2: as shown in FIG. 25, which is a planar structural diagram of a first through hole 511, a pixel opening 61 and a first electrode 41 of a light-emitting device F that are in a display panel 10 in accordance with some embodiments, the first length corresponding to the light-emitting device F in the display panel 10 is L1, and the second length corresponding to the light-emitting device F in the display panel 10 is L2.

L1 is greater than or equal to 7 µm. Alternatively, L1 is less than 7 µm, and L2 = n × L1 + m, where -1.5 ≥ n ≥ -3 and 30 ≥ m ≥ 20.

In the case where the first length L1 corresponding to the light-emitting device F in the display panel 10 is greater than or equal to 7 µm, the first length L1 corresponding to the light-emitting device F in the display panel 10 is relatively large, and thus in orthographic projections on the substrate 1 in the display panel 10, the minimum distance on the reference line C between the boundary of the first through hole 511 (i.e., the boundary of the second opening 511b of the first through hole 511) corresponding to the light-emitting device F in the display panel 10 and the boundary of the pixel opening 61 of the pixel definition layer 6 corresponding to the same light-emitting device F is relatively large. That is, the distance between the first through hole 511 corresponding to the light-emitting device F in the display panel 10 and the pixel opening 61 of the pixel definition layer 6 corresponding to the same light-emitting device F is relatively large. Thus, it is possible to reduce the proportion of the overlapping region 41c between the effective light-emitting portion 41b and the first portion 41a of the first electrode 41 of the light-emitting device F in the effective light-emitting portion 41b of the first electrode 41 of the light-emitting device F, which may reduce the influence of the overlapping region 41c between the effective light-emitting portion 41b and the first portion 41a of the first electrode 41 on the flatness of the effective light-emitting portion 41b of the first electrode 41. As a result, it is beneficial to improve the flatness of the effective light-emitting portion 41b of the first electrode 41 of the light-emitting device F, and also beneficial to improve the light emission symmetry of the light-emitting device F located in the secondary display area A2 of the display panel 10. When the human eyes view the display panel 10 at an oblique viewing angle, it is possible to reduce the probability of color difference between the main display area A1 and the secondary display area A2 of the display panel 10 (for example, the probability that the image displayed in the secondary display area A2 of the display panel 10 appears reddish, greenish, or purplish), which is beneficial to improving the display uniformity of the display panel 10 and the display effect of the display panel 10.

In the case where the first length L1 corresponding to the light-emitting device F in the display panel 10 is less than 7 µm, the first length L1 corresponding to the light-emitting device F in the display panel 10 is relatively small, and thus in orthographic projections on the substrate 1 in the display panel 10, the minimum distance on the reference line C between the boundary of the first through hole 511 (i.e., the boundary of the second opening 511b of the first through hole 511) corresponding to the light-emitting device F in the display panel 10 and the boundary of the pixel opening 61 of the pixel definition layer 6 corresponding to the same light-emitting device F is relatively small. That is, the distance between the first through hole 511 corresponding to the light-emitting device F in the display panel 10 and the pixel opening 61 of the pixel definition layer 6 corresponding to the same light-emitting device F is relatively small. By setting the second length L2 corresponding to the light-emitting device F in the display panel 10 to satisfy L2 = n × L1 + m (where -1.5 ≥ n ≥ -3, and 30 ≥ m ≥ 20), the second length L2 corresponding to the light-emitting device F in the display panel 10 is negatively correlated with the first length L1 corresponding to the light-emitting device F (that is, when the first length L1 corresponding to the light-emitting device F is relatively small, the second length L2 corresponding to the light-emitting device F is relatively large), and the length, on the reference line C, of the effective light-emitting portion 41b of the first electrode 41 of the light-emitting device F is relatively large. Thus, it is possible to reduce the proportion of the overlapping region 41c between the effective light-emitting portion 41b and the first portion 41a of the first electrode 41 of the light-emitting device F in the effective light-emitting portion 41b of the first electrode 41 of the light-emitting device F, which may reduce the influence of the overlapping region 41c between the effective light-emitting portion 41b and the first portion 41a of the first electrode 41 on the flatness of the effective light-emitting portion 41b of the first electrode 41. As a result, it is beneficial to improve the flatness of the effective light-emitting portion 41b of the first electrode 41 of the light-emitting device F, and also beneficial to improve the light emission symmetry of the light-emitting device F located in the secondary display area A2 of the display panel 10. When the human eyes view the display panel 10 at an oblique viewing angle, it is possible to reduce the probability of color difference between the main display area A1 and the secondary display area A2 of the display panel 10 (for example, the probability that the image displayed in the secondary display area A2 of the display panel 10 appears reddish, greenish, or purplish), which is beneficial to improving the display uniformity of the display panel 10 and the display effect of the display panel 10.

For example, in the case where the first length L1 corresponding to the light-emitting device F in the display panel 10 is greater than or equal to 7 µm, the first length L1 corresponding to the light-emitting device F in the display panel 10 may be 7 µm, 7.5 µm, 8 µm, 8.5 µm, 9 µm, 9.5 µm, 10 µm, 10.5 µm, 11 µm, 11.5 µm, 12 µm, 12.5 µm, or 13 µm.

For example, in the case where the first length L1 corresponding to the light-emitting device F in the display panel 10 is less than 7 µm, the first length L1 corresponding to the light-emitting device F in the display panel 10 may be 6.8 µm, 6.5 µm, 6.3 µm, 6 µm, 5.8 µm, 5.5 µm, 5.3 µm, 5 µm, 4.8 µm, 4.5 µm, 4.3 µm, 4 µm, or 3.9 µm.

n may be -1.5, -1.8, -2, -2.3, -2.5, -2.8, or -3.

m may be 20, 23, 25, 28, or 30.

For example, with continued reference to FIG. 25 and in conjunction with FIG. 13, the first length corresponding to the light-emitting device F in the display panel 10 is L1, and the second length corresponding to the light-emitting device F in the display panel 10 is L2; L1 is greater than or equal to 7 µm, or L1 is less than 7 µm, and L2 = n × L1 + m, where -1.5 ≥ n ≥ -3 and 30 ≥ m ≥ 20. In this case, multiple (e.g., five) points may be arbitrarily selected on a surface of the effective light-emitting portion 41b of the first electrode 41 in the display panel 10 away from the substrate 1, and a slope of a straight line formed by connecting the multiple (e.g., five) points may be less than 0.008. As a result, the flatness of the effective light-emitting portion 41b of the first electrode 41 of the light-emitting device F is relatively high, which is beneficial to reducing the influence of the effective light-emitting portion 41b of the first electrode 41 on the color shift symmetry of the secondary display area A2 of the display panel 10. When the human eyes view the display panel 10 at an oblique viewing angle, it is possible to reduce the probability of color difference between the main display area A1 and the secondary display area A2 of the display panel 10 (for example, the probability that the image displayed in the secondary display area A2 of the display panel 10 appears reddish, greenish, or purplish), which is beneficial to improving the display uniformity of the display panel 10 and the display effect of the display panel 10.

For example, with continued reference to FIG. 25, in a case where it is necessary to increase the second length L2 corresponding to the light-emitting device F in the display panel 10, when forming the pixel opening 61 in the pixel definition layer 6 in the display panel 10, the pixel definition layer 6 in the display panel 10 may be overexposed (e.g., by increasing the exposure time and/or increasing the exposure intensity, etc.), so that the dimension of the pixel opening 61 of the pixel definition layer 6 may be increased, thereby increasing the second length L2 of the light-emitting device F corresponding to the pixel opening 61.

Embodiment 3 of the present disclosure will be described in detail below.

Embodiment 3: as shown in FIG. 26, which is a planar structural diagram of a first through hole 511, a pixel opening 61 and a first electrode 41 of a light-emitting device F that are in a display panel 10 in accordance with some embodiments, inner diameters of the pixel opening 61 of the pixel definition layer 6 along different axial directions are not completely equal, and the pixel opening 61 of the pixel definition layer 6 has the maximum inner diameter with a value of R1 along the axis of the preset direction N (i.e., the direction in which the main body portion 411 and the connection portion 412 of the first electrode 41 of the light-emitting device F are connected). That is, in the case where the inner diameters of the pixel opening 61 of the pixel definition layer 6 along different axial directions are not completely equal, the second length L2 corresponding to the light-emitting device F in the display panel 10 is equal to the value R1 of the maximum inner diameter of the pixel opening 61 of the pixel definition layer 6 corresponding to the light-emitting device F.

In the case where the inner diameters of the pixel opening 61 of the pixel definition layer 6 along different axial directions are not completely equal, by making the pixel opening 61 of the pixel definition layer 6 have the maximum inner diameter with the value of R1 along the axis of the preset direction N (i.e., the direction in which the main body portion 411 and the connection portion 412 of the first electrode 41 of the light-emitting device F are connected), the second length L2 of the light-emitting device F corresponding to the pixel opening 61 is relatively large, and the length, on the reference line C, of the effective light-emitting portion 41b of the first electrode 41 of the light-emitting device F is relatively large. Thus, it is possible to reduce the proportion of the overlapping region 41c between the effective light-emitting portion 41b and the first portion 41a of the first electrode 41 of the light-emitting device F in the effective light-emitting portion 41b of the first electrode 41 of the light-emitting device F, which may reduce the influence of the overlapping region 41c between the effective light-emitting portion 41b and the first portion 41a of the first electrode 41 on the flatness of the effective light-emitting portion 41b of the first electrode 41. As a result, it is beneficial to improve the flatness of the effective light-emitting portion 41b of the first electrode 41 of the light-emitting device F, and also beneficial to improve the light emission symmetry of the light-emitting device F located in the secondary display area A2 of the display panel 10. When the human eyes view the display panel 10 at an oblique viewing angle, it is possible to reduce the probability of color difference between the main display area A1 and the secondary display area A2 of the display panel 10 (for example, the probability that the image displayed in the secondary display area A2 of the display panel 10 appears reddish, greenish, or purplish), which is beneficial to improving the display uniformity of the display panel 10 and the display effect of the display panel 10.

It should be noted that the embodiment shown in FIG. 26 only illustrates an example where the pixel opening 61 of the pixel definition layer 6 is in a shape of an ellipse in the case where the inner diameters of the pixel opening 61 of the pixel definition layer 6 along different axial directions are not completely equal. However, in the present disclosure, in the case where the inner diameters of the pixel opening 61 of the pixel definition layer 6 along different axial directions are not completely equal, the shape of the pixel opening 61 of the pixel definition layer 6 is not limited to this. For example, in the case where the inner diameters of the pixel opening 61 of the pixel definition layer 6 along different axial directions are not completely equal, the pixel opening 61 of the pixel definition layer 6 may also be in a shape of a rectangle, a triangle, a rhombus, or any other shape with corners.

Embodiment 4 of the present disclosure will be described in detail below.

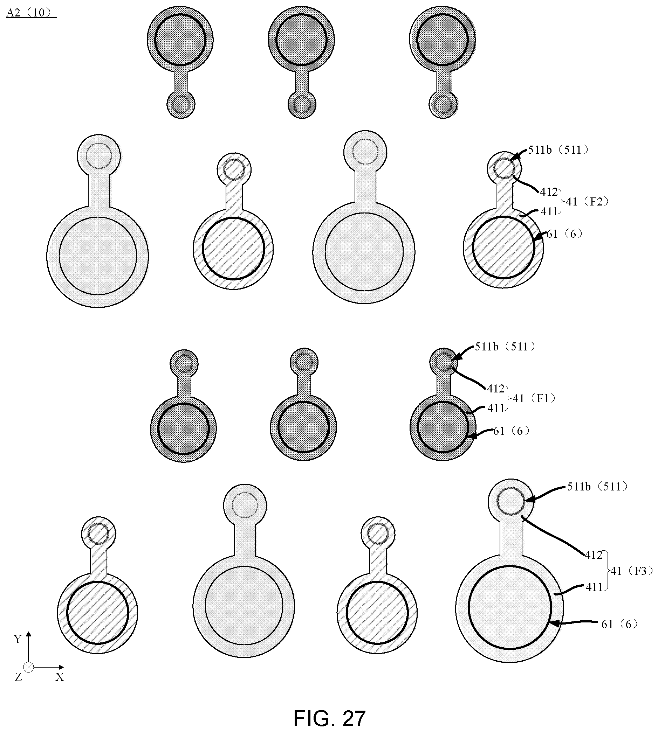

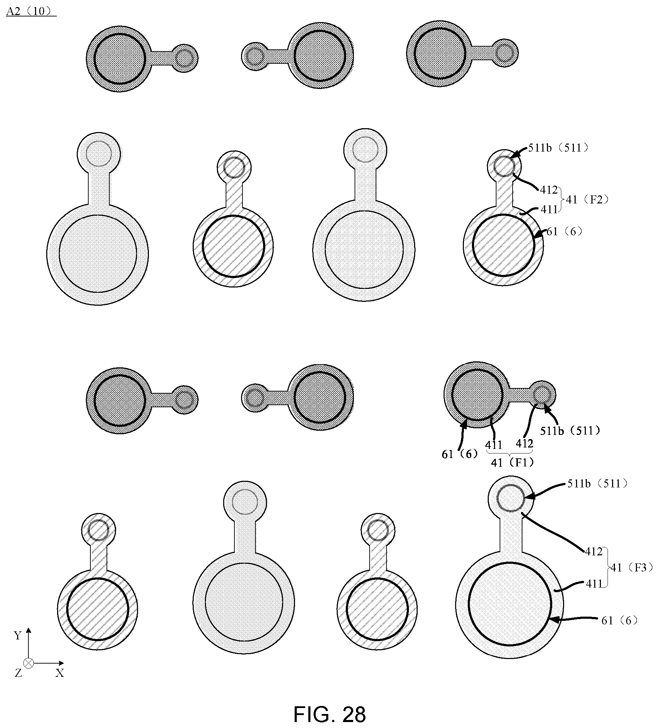

Embodiment 4, as shown in FIGS. 27 and 28 (which are each a planar structural diagram of a partial region of a secondary display area A2 of a display panel 10, in accordance with some embodiments), and in conjunction with FIG. 25, the light-emitting devices F located in the secondary display area A2 of the display panel 10 are arranged in an array along the row direction X and the column direction Y, and the light-emitting devices F located in the secondary display area A2 of the display panel 10 include the first color light-emitting devices F1; and in this case, along the column direction Y, first through holes 511 corresponding to first electrodes 41 in two adjacent rows of first color light-emitting devices F1 are located between pixel openings 61 corresponding to the first electrodes 41 in the two adjacent rows of first color light-emitting devices F1 (this situation is shown in FIG. 27).

Alternatively, along the row direction X, first through holes 511 corresponding to first electrodes 41 in two adjacent columns of first color light-emitting devices F1 are located between pixel openings 61 corresponding to the first electrodes 41 in the two adjacent columns of first color light-emitting devices F1 (this situation is shown in FIG. 28).

In the case where the light-emitting devices F located in the secondary display area A2 of the display panel 10 are arranged in an array along the row direction X and the column direction Y, along the column direction Y, the first through holes 511 corresponding to the first electrodes 41 in two adjacent rows of first color light-emitting devices F1 are located between the pixel openings 61 corresponding to the first electrodes 41 in the two adjacent rows of first color light-emitting devices F1; and therefore, along the column direction Y, the first portions 41a of the first electrodes 41 in the two adjacent rows of first color light-emitting devices F1 are located between the pixel openings 61 corresponding to the first electrodes 41 in the two adjacent rows of first color light-emitting devices F1. As a result, along the column direction Y, the overlapping regions 41c each between the effective light-emitting portion 41b and the first portion 41a of the first electrode 41 in the two adjacent rows of first color light-emitting devices F1 are located between the pixel openings 61 corresponding to the first electrodes 41 in the two adjacent rows of first color light-emitting devices F1.

In the effective light-emitting portion 41b of the first electrode 41 of the first color light-emitting device F1, the flatness of the overlapping region 41c between the effective light-emitting portion 41b and the first portion 41a of the first electrode 41 of the first color light-emitting device F1 is generally lower than the flatness of other portions, so that the light emission symmetry of the overlapping region 41c between the effective light-emitting portion 41b and the first portion 41a of the first electrode 41 of the first color light-emitting device F1 is relatively poor. Along the column direction Y, the overlapping regions 41c each between the effective light-emitting portion 41b and the first portion 41a of the first electrode 41 in the two adjacent rows of first color light-emitting devices F1 are located between the pixel openings 61 corresponding to the first electrodes 41 in the two adjacent rows of first color light-emitting devices F1; and therefore, along the column direction Y, light emitted from the regions with relatively poor light emission symmetry in the effective light-emitting portions 41b of the first electrodes 41 in the two adjacent rows of first color light-emitting devices F1 (i.e., light emitted from the overlapping regions 41c between the effective light-emitting portions 41b and the first portions 41a of the first electrodes 41 in the first color light-emitting devices F1) may cancel each other out. As a result, it is beneficial to improve the light emission symmetry of the first color light-emitting device F1 located in the secondary display area A2 of the display panel 10. When the human eyes view the display panel 10 at an oblique viewing angle, it is possible to reduce the probability of color difference between the main display area A1 and the secondary display area A2 of the display panel 10 (for example, the probability that the image displayed in the secondary display area A2 of the display panel 10 appears reddish, greenish, or purplish), which is beneficial to improving the display uniformity of the display panel 10 and the display effect of the display panel 10.

Alternatively, in the case where the light-emitting devices F located in the secondary display area A2 of the display panel 10 are arranged in an array along the row direction X and the column direction Y, along the row direction X, the first through holes 511 corresponding to the first electrodes 41 in two adjacent columns of first color light-emitting devices F1 are located between the pixel openings 61 corresponding to the first electrodes 41 in the two adjacent columns of first color light-emitting devices F1; and therefore, along the row direction X, the first portions 41a of the first electrodes 41 in the two adjacent columns of first color light-emitting devices F1 are located between the pixel openings 61 corresponding to the first electrodes 41 in the two adjacent columns of first color light-emitting devices F1. As a result, along the row direction X, the overlapping regions 41c each between the effective light-emitting portion 41b and the first portion 41a of the first electrode 41 in the two adjacent columns of first color light-emitting devices F1 are located between the pixel openings 61 corresponding to the first electrodes 41 in the two adjacent columns of first color light-emitting devices F1.

In the effective light-emitting portion 41b of the first electrode 41 of the first color light-emitting device F1, the flatness of the overlapping region 41c between the effective light-emitting portion 41b and the first portion 41a of the first electrode 41 of the first color light-emitting device F1 is generally lower than the flatness of other portions, so that the light emission symmetry of the overlapping region 41c between the effective light-emitting portion 41b and the first portion 41a of the first electrode 41 of the first color light-emitting device F1 is relatively poor. Along the row direction X, the overlapping regions 41c each between the effective light-emitting portion 41b and the first portion 41a of the first electrode 41 in the two adjacent columns of first color light-emitting devices F1 are located between the pixel openings 61 corresponding to the first electrodes 41 in the two adjacent columns of first color light-emitting devices F1; and therefore, along the row direction X, light emitted from the regions with relatively poor light emission symmetry in the effective light-emitting portions 41b of the first electrodes 41 in the two adjacent columns of first color light-emitting devices F1 (i.e., light emitted from the overlapping regions 41c between the effective light-emitting portions 41b and the first portions 41a of the first electrodes 41 in the first color light-emitting devices F1) may cancel each other out. As a result, it is beneficial to improve the light emission symmetry of the first color light-emitting device F1 located in the secondary display area A2 of the display panel 10. When the human eyes view the display panel 10 at an oblique viewing angle, it is possible to reduce the probability of color difference between the main display area A1 and the secondary display area A2 of the display panel 10 (for example, the probability that the image displayed in the secondary display area A2 of the display panel 10 appears reddish, greenish, or purplish), which is beneficial to improving the display uniformity of the display panel 10 and the display effect of the display panel 10.

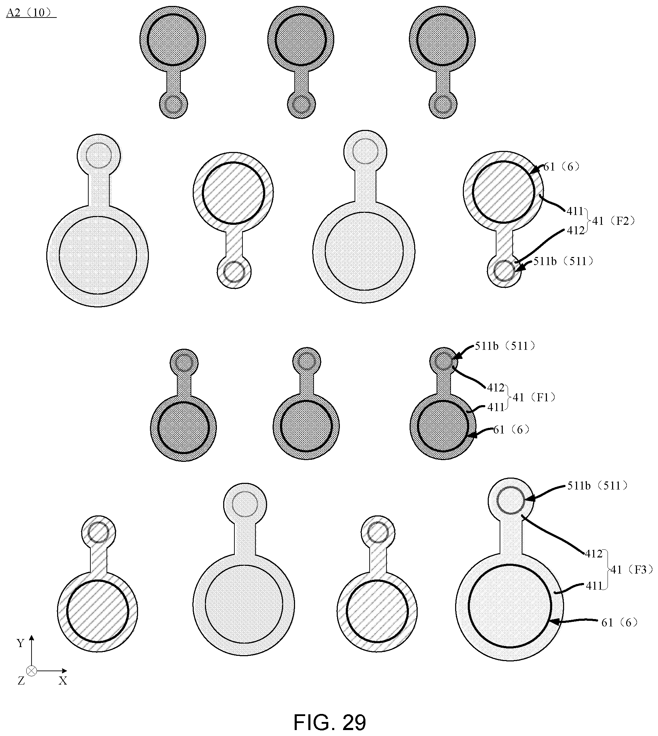

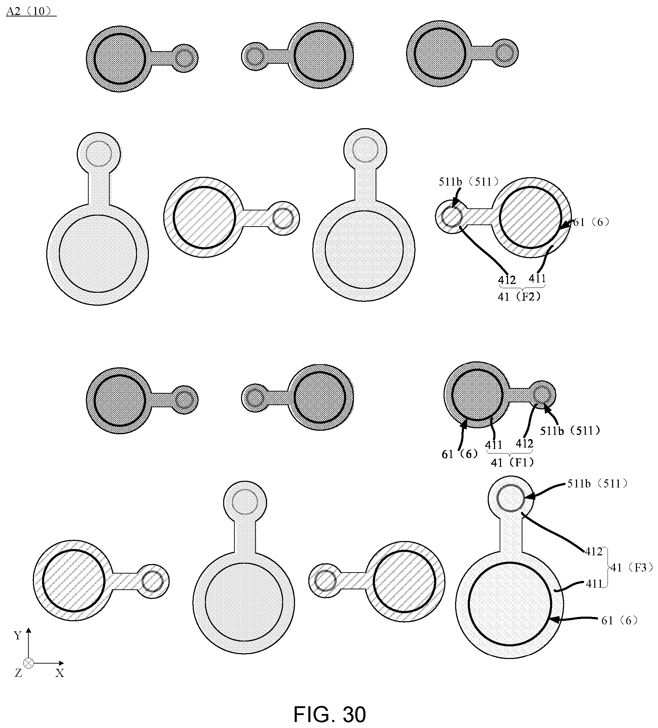

For example, as shown in FIGS. 29 and 30 (which are each a planar structural diagram of a partial region of a secondary display area A2 of a display panel 10, in accordance with some embodiments), and in conjunction with FIG. 25, the light-emitting devices F located in the secondary display area A2 of the display panel 10 are arranged in an array along the row direction X and the column direction Y, and the light-emitting devices F located in the secondary display area A2 of the display panel 10 include the second color light-emitting devices F2; and in this case, along the column direction Y, first through holes 511 corresponding to first electrodes 41 in two adjacent rows of second color light-emitting devices F2 are located between pixel openings 61 corresponding to the first electrodes 41 in the two adjacent rows of second color light-emitting devices F2 (this situation is shown in FIG. 29).

Alternatively, along the row direction X, first through holes 511 corresponding to first electrodes 41 in two adjacent columns of second color light-emitting devices F2 are located between pixel openings 61 corresponding to the first electrodes 41 in the two adjacent columns of second color light-emitting devices F2 (this situation is shown in FIG. 30).

In the case where the light-emitting devices F located in the secondary display area A2 of the display panel 10 are arranged in an array along the row direction X and the column direction Y, and the light-emitting devices F located in the secondary display area A2 of the display panel 10 include the second color light-emitting devices F2, along the column direction Y, first through holes 511 corresponding to first electrodes 41 in two adjacent rows of second color light-emitting devices F2 are located between pixel openings 61 corresponding to the first electrodes 41 in the two adjacent rows of second color light-emitting devices F2.

Alternatively, along the row direction X, first through holes 511 corresponding to first electrodes 41 in two adjacent columns of second color light-emitting devices F2 are located between pixel openings 61 corresponding to the first electrodes 41 in the two adjacent columns of second color light-emitting devices F2.

In the case where the light-emitting devices F located in the secondary display area A2 of the display panel 10 are arranged in an array along the row direction X and the column direction Y, along the column direction Y, the first through holes 511 corresponding to the first electrodes 41 in two adjacent rows of second color light-emitting devices F2 are located between the pixel openings 61 corresponding to the first electrodes 41 in the two adjacent rows of second color light-emitting devices F2; and therefore, along the column direction Y, the first portions 41a of the first electrodes 41 in the two adjacent rows of second color light-emitting devices F2 are located between the pixel openings 61 corresponding to the first electrodes 41 in the two adjacent rows of second color light-emitting devices F2. As a result, along the column direction Y, the overlapping regions 41c each between the effective light-emitting portion 41b and the first portion 41a of the first electrode 41 in the two adjacent rows of second color light-emitting devices F2 are located between the pixel openings 61 corresponding to the first electrodes 41 in the two adjacent rows of second color light-emitting devices F2.

In the effective light-emitting portion 41b of the first electrode 41 of the second color light-emitting device F2, the flatness of the overlapping region 41c between the effective light-emitting portion 41b and the first portion 41a of the first electrode 41 of the second color light-emitting device F2 is generally lower than the flatness of other portions, so that the light emission symmetry of the overlapping region 41c between the effective light-emitting portion 41b and the first portion 41a of the first electrode 41 of the second color light-emitting device F2 is relatively poor. Along the column direction Y, the overlapping regions 41c each between the effective light-emitting portion 41b and the first portion 41a of the first electrode 41 in the two adjacent rows of second color light-emitting devices F2 are located between the pixel openings 61 corresponding to the first electrodes 41 in the two adjacent rows of second color light-emitting devices F2; and therefore, along the column direction Y, light emitted from the regions with relatively poor light emission symmetry in the effective light-emitting portions 41b of the first electrodes 41 in the two adjacent rows of second color light-emitting devices F2 (i.e., light emitted from the overlapping regions 41c between the effective light-emitting portions 41b and the first portions 41a of the first electrodes 41 in the second color light-emitting devices F2) may cancel each other out. As a result, it is beneficial to improve the light emission symmetry of the second color light-emitting device F2 located in the secondary display area A2 of the display panel 10. When the human eyes view the display panel 10 at an oblique viewing angle, it is possible to reduce the probability of color difference between the main display area A1 and the secondary display area A2 of the display panel 10 (for example, the probability that the image displayed in the secondary display area A2 of the display panel 10 appears reddish, greenish, or purplish), which is beneficial to improving the display uniformity of the display panel 10 and the display effect of the display panel 10.

Alternatively, in the case where the light-emitting devices F located in the secondary display area A2 of the display panel 10 are arranged in an array along the row direction X and the column direction Y, along the row direction X, the first through holes 511 corresponding to the first electrodes 41 in two adjacent columns of second color light-emitting devices F2 are located between the pixel openings 61 corresponding to the first electrodes 41 in the two adjacent columns of second color light-emitting devices F2; and therefore, along the row direction X, the first portions 41a of the first electrodes 41 in the two adjacent columns of second color light-emitting devices F2 are located between the pixel openings 61 corresponding to the first electrodes 41 in the two adjacent columns of second color light-emitting devices F2. As a result, along the row direction X, the overlapping regions 41c each between the effective light-emitting portion 41b and the first portion 41a of the first electrode 41 in the two adjacent columns of second color light-emitting devices F2 are located between the pixel openings 61 corresponding to the first electrodes 41 in the two adjacent columns of second color light-emitting devices F2.

In the effective light-emitting portion 41b of the first electrode 41 of the second color light-emitting device F2, the flatness of the overlapping region 41c between the effective light-emitting portion 41b and the first portion 41a of the first electrode 41 of the second color light-emitting device F2 is generally lower than the flatness of other portions, so that the light emission symmetry of the overlapping region 41c between the effective light-emitting portion 41b and the first portion 41a of the first electrode 41 of the second color light-emitting device F2 is relatively poor. Along the row direction X, the overlapping regions 41c each between the effective light-emitting portion 41b and the first portion 41a of the first electrode 41 in the two adjacent columns of second color light-emitting devices F2 are located between the pixel openings 61 corresponding to the first electrodes 41 in the two adjacent columns of second color light-emitting devices F2; and therefore, along the row direction X, light emitted from the regions with relatively poor light emission symmetry in the effective light-emitting portions 41b of the first electrodes 41 in the two adjacent columns of second color light-emitting devices F2 (i.e., light emitted from the overlapping regions 41c between the effective light-emitting portions 41b and the first portions 41a of the first electrodes 41 in the second color light-emitting devices F2) may cancel each other out. As a result, it is beneficial to improve the light emission symmetry of the second color light-emitting device F2 located in the secondary display area A2 of the display panel 10. When the human eyes view the display panel 10 at an oblique viewing angle, it is possible to reduce the probability of color difference between the main display area A1 and the secondary display area A2 of the display panel 10 (for example, the probability that the image displayed in the secondary display area A2 of the display panel 10 appears reddish, greenish, or purplish), which is beneficial to improving the display uniformity of the display panel 10 and the display effect of the display panel 10.

It should be noted that, in the case where the light-emitting devices F located in the secondary display area A2 of the display panel 10 are arranged in an array along the row direction X and the column direction Y, and the light-emitting devices F located in the secondary display area A2 of the display panel 10 include the third color light-emitting devices F3, along the column direction Y, first through holes 511 corresponding to first electrodes 41 in two adjacent rows of third color light-emitting devices F3 are located between pixel openings 61 corresponding to the first electrodes 41 in the two adjacent rows of third color light-emitting devices F3; or along the row direction X, first through holes 511 corresponding to first electrodes 41 in two adjacent columns of third color light-emitting devices F3 are located between pixel openings 61 corresponding to the first electrodes 41 in the two adjacent columns of third color light-emitting devices F3, which will not be repeated here.

Furthermore, in the case where the light-emitting devices F located in the secondary display area A2 of the display panel 10 include the first color light-emitting devices F1, the second color light-emitting devices F2, and the third color light-emitting devices F3, the above-mentioned arrangement may be made for at least one of the first color light-emitting devices F1, the second color light-emitting devices F2, and the third color light-emitting devices F3 based on actual needs.

Embodiment 5 of the present disclosure will be described in detail below.

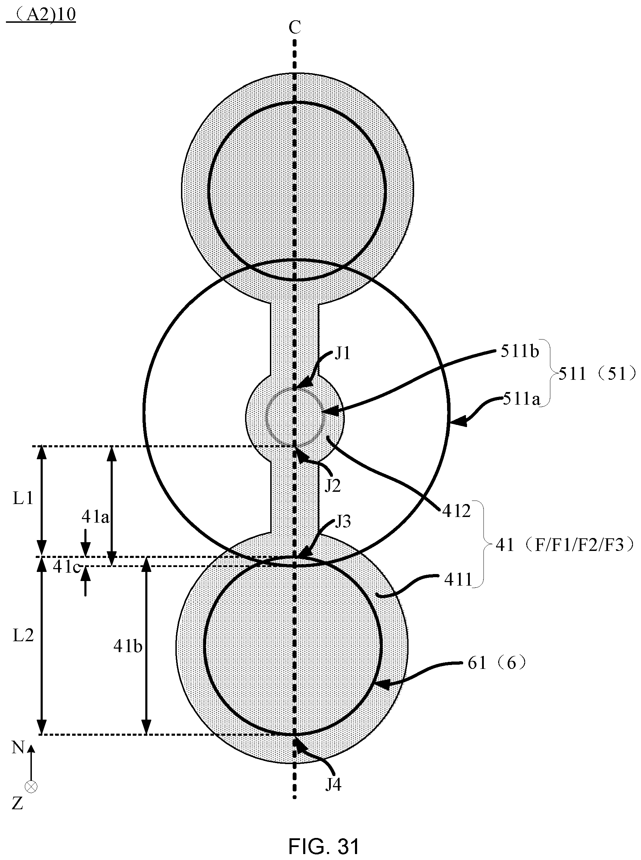

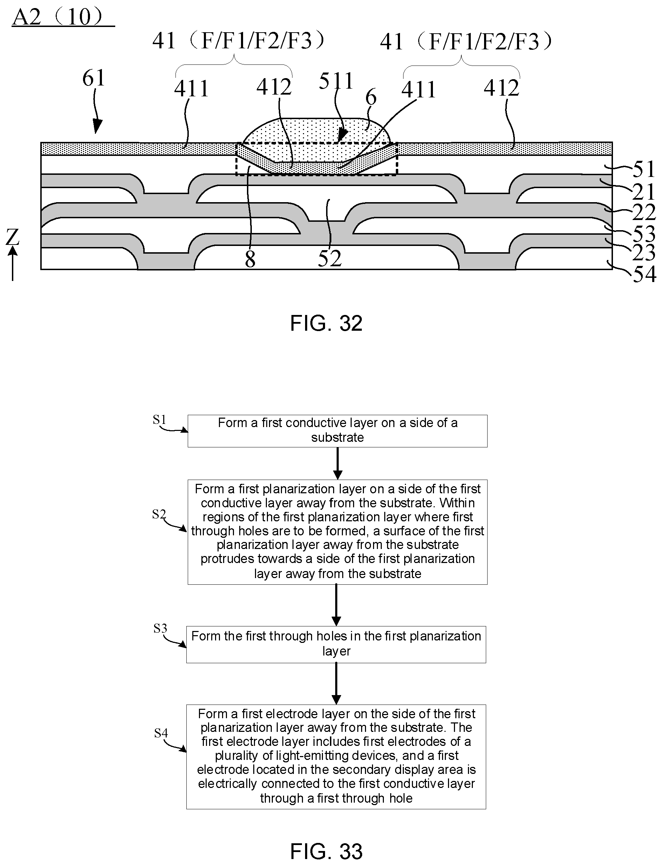

Embodiment 5: as shown in FIGS. 31 and 32 (where FIG. 31 is a planar structural diagram of a first through hole 511, a pixel opening 61 and a first electrode 41 of a light-emitting device F that are in a display panel 10 in accordance with some embodiments, and FIG. 32 is a film-layer structural diagram of a partial region of a secondary display area A2 of a display panel 10 in accordance with some embodiments), first electrodes 41 of at least two light-emitting devices F located in the secondary display area A2 of the display panel 10 are electrically connected to the first conductive layer 21 through the same first through hole 511.

The first electrodes 41 of the at least two light-emitting devices F located in the secondary display area A2 of the display panel 10 are electrically connected to the first conductive layer 21 through the same first through hole 511, so that the first electrodes 41 of the at least two light-emitting devices F located in the secondary display area A2 of the display panel 10 may share the same first through hole 511 to be electrically connected to the first conductive layer 21. This helps to reduce the number of first through holes 511 in the secondary display area A2 of the display panel 10, and thus helps to increase the wiring space in the secondary display area A2 of the display panel 10. Moreover, this may increase the first length L1 corresponding to the light-emitting device F in the display panel 10, so that the first length L1 corresponding to the light-emitting device F in the display panel 10 may be relatively large. In this way, in orthographic projections on the substrate 1 in the display panel 10, the minimum distance on the reference line C between the boundary of the first through hole 511 (i.e., the boundary of the second opening 511b of the first through hole 511) corresponding to the light-emitting device F in the display panel 10 and the boundary of the pixel opening 61 of the pixel definition layer 6 corresponding to the same light-emitting device F is relatively large. That is, the distance between the first through hole 511 corresponding to the light-emitting device F in the display panel 10 and the pixel opening 61 of the pixel definition layer 6 corresponding to the same light-emitting device F is relatively large. Thus, it is possible to reduce the proportion of the overlapping region 41c between the effective light-emitting portion 41b and the first portion 41a of the first electrode 41 of the light-emitting device F in the effective light-emitting portion 41b of the first electrode 41 of the light-emitting device F, which may reduce the influence of the overlapping region 41c between the effective light-emitting portion 41b and the first portion 41a of the first electrode 41 on the flatness of the effective light-emitting portion 41b of the first electrode 41. As a result, it is beneficial to improve the flatness of the effective light-emitting portion 41b of the first electrode 41 of the light-emitting device F, and also beneficial to improve the light emission symmetry of the light-emitting device F located in the secondary display area A2 of the display panel 10. When the human eyes view the display panel 10 at an oblique viewing angle, it is possible to reduce the probability of color difference between the main display area A1 and the secondary display area A2 of the display panel 10 (for example, the probability that the image displayed in the secondary display area A2 of the display panel 10 appears reddish, greenish, or purplish), which is beneficial to improving the display uniformity of the display panel 10 and the display effect of the display panel 10.

For example, with continued reference to FIGS. 31 and 32, first electrodes 41 of two light-emitting devices F located in the secondary display area A2 of the display panel 10 are electrically connected to the first conductive layer 21 through the same first through hole 511.

Alternatively, first electrodes 41 of multiple (more than two) light-emitting devices F located in the secondary display area A2 of the display panel 10 are electrically connected to the first conductive layer 21 through the same first through hole 511.

For example, with continued reference to FIGS. 31 and 32, in the case where the first electrodes 41 of the two light-emitting devices F located in the secondary display area A2 of the display panel 10 are electrically connected to the first conductive layer 21 through the same first through hole 511, the first electrodes 41 of the two light-emitting devices F can be located on opposite sides of the first through hole 511.

Embodiment 6 of the present disclosure will be described in detail below.

Embodiment 6: as shown in FIG. 33, FIG. 33 is a flowchart of a manufacturing method for a display panel 10, in accordance with some embodiments. It should be noted that, the manufacturing method for the display panel 10 shown in FIG. 33 is not exclusive, and other steps may be performed before, after or between any step in the manufacturing method for the display panel 10 shown in FIG. 33.

The manufacturing method for the display panel 10 includes steps S1 to S4.

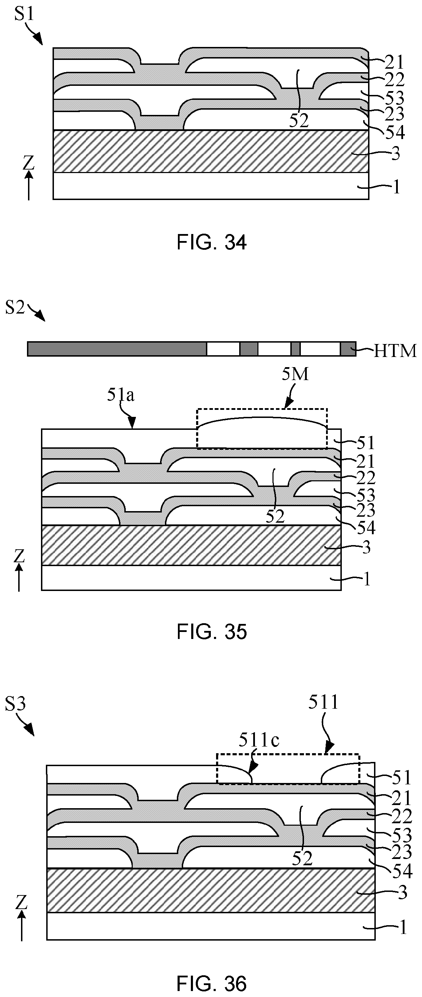

In S1, as shown in FIG. 34, which is a structural diagram of a display panel 10 corresponding to step S1 in the flowchart of the manufacturing method for the display panel 10 in FIG. 33, a first conductive layer 21 is formed on a side of the substrate 1.

In S2, as shown in FIG. 35, which is a structural diagram of a display panel 10 corresponding to step S2 in the flowchart of the manufacturing method for the display panel 10 in FIG. 33, a first planarization layer 51 is formed on a side of the first conductive layer 21 away from the substrate 1. Within regions 5M of the first planarization layer 51 where first through holes are to be formed, a surface 51a of the first planarization layer 51 away from the substrate 1 protrudes towards a side of the first planarization layer 51 away from the substrate 1.

In S3, as shown in FIG. 36, which is a structural diagram of a display panel 10 corresponding to step S3 in the flowchart of the manufacturing method for the display panel 10 in FIG. 33, the first through holes 511 are formed in the first planarization layer 51.

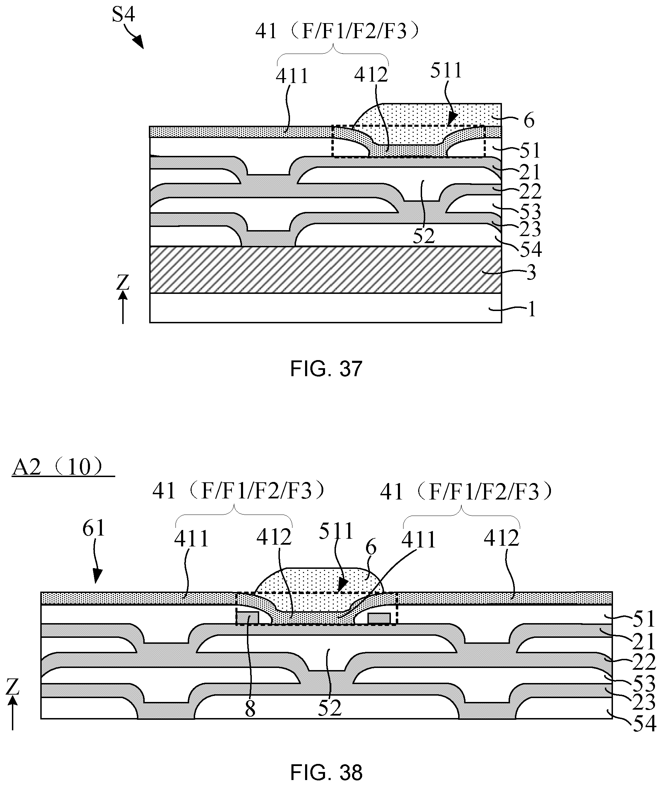

In S3, as shown in FIG. 37, which is a structural diagram of a display panel 10 corresponding to step S4 in the flowchart of the manufacturing method for the display panel 10 in FIG. 33, a first electrode layer 4 is formed on the side of the first planarization layer 51 away from the substrate 1. The first electrode layer 4 includes first electrodes 41 of a plurality of light-emitting devices F, and a first electrode 41 located in the secondary display area A2 passes through a first through hole 511 and is connected to the first conductive layer 21.

When the first planarization layer 51 is formed in the display panel 10, the surface 51a of the first planarization layer 51 away from the substrate 1 protrudes towards the side of the first planarization layer 51 away from the substrate 1 within the region 5M of the first planarization layer 51 where the first through hole is to be formed, so that the material loss of the first planarization layer 51 at a part of the sidewall 511c of the first through hole 511 may be offset when the first through hole 511 is formed in the first planarization layer 51. As a result, in a section of the display panel 10 parallel to the third direction Z (i.e., the thickness direction of the display panel 10), the sidewall 511c of the first through hole 511 is arc-shaped and protrudes towards the interior of the first through hole 511. Moreover, it is possible to improve the flatness of a partial region, adjacent to the surface 51a of the first planarization layer 51 away from the substrate 1, in the sidewall 511c of the first through hole 511, and in turn improve the flatness of a portion of the first electrode 41 (i.e., the first portion 41a of the first electrode 41) covering the sidewall 511c of the first through hole 511. In this way, the flatness of the overlapping region 41c between the effective light-emitting portion 41b and the first portion 41a of the first electrode 41 is relatively high, thereby improving the flatness of the effective light-emitting portion 41b of the first electrode 41 and helping to improve the light emission symmetry of the light-emitting device F located in the secondary display area A2 of the display panel 10. When the human eyes view the display panel 10 at an oblique viewing angle, it is possible to reduce the probability of color difference between the main display area A1 and the secondary display area A2 of the display panel 10 (for example, the probability that the image displayed in the secondary display area A2 of the display panel 10 appears reddish, greenish, or purplish), which is beneficial to improving the display uniformity of the display panel 10 and the display effect of the display panel 10.

For example, the first planarization layer 51 can be processed by a half-tone mask (HTM) process, so that the surface 51a of the first planarization layer 51 away from the substrate 1 protrudes towards the side of the first planarization layer 51 away from the substrate 1 within the region 5M of the first planarization layer 51 where the first through hole is to be formed.

The above "half-tone mask (HTM) process" is a mask technology that can simulate continuous grayscale images, and use dots of different sizes, densities, or shapes to adjust the light intensity distribution transmitted through the mask, thereby controlling a thickness or concentration of the material in the exposed region to manufacture a film layer with gradients.

It should be noted that the above merely describes Embodiment 1 to Embodiment 6 of the present disclosure with reference to FIGS. 14 to 37. However, the embodiments of the present disclosure are not limited to these. Any two or more embodiments in Embodiments 1 to 6 may be arbitrarily combined to form new embodiments.

For example, Embodiment 1 may be combined with any one or more of Embodiments 2 to 6 to further improve the light emission symmetry of the light-emitting device F located in the secondary display area A2 of the display panel 10. When the human eyes view the display panel 10 at an oblique viewing angle, it is possible to further reduce the probability of color difference between the main display area A1 and the secondary display area A2 of the display panel 10 (for example, the probability that the image displayed in the secondary display area A2 of the display panel 10 appears reddish, greenish, or purplish), which is beneficial to further improving the display uniformity of the display panel 10 and the display effect of the display panel 10.

Specifically, with continued reference to FIG. 38, FIG. 38 is a film-layer structural diagram of a partial region of a secondary display area A2 of a display panel 10, in accordance with some embodiments. In an example where Embodiment 1 is combined with Embodiments 5, the display panel 10 includes the support portion 8 located in the secondary display area A2 of the display panel 10, and the first planarization layer 51 in the display panel 10 covers the support portion 8; and the support portion 8 is close to the first through hole 511 of the first planarization layer 51, and is located on a side of the first through hole 511 of the first planarization layer 51 close to the center of the first electrode 41 of the light-emitting device F. Moreover, the first electrodes 41 of at least two light-emitting devices F located in the secondary display area A2 of the display panel 10 can be electrically connected to the first conductive layer 21 through the same first through hole 511.

For example, with continued reference to FIG. 38, the first electrodes 41 of two light-emitting devices F located in the secondary display area A2 of the display panel 10 are electrically connected to the first conductive layer 21 through the same first through hole 511.

Alternatively, the first electrodes 41 of multiple (more than two) light-emitting devices F located in the secondary display area A2 of the display panel 10 are electrically connected to the first conductive layer 21 through the same first through hole 511.

For example, the support portion 8 in the display panel 10 can be arranged around the first through hole 511.

For example, with continued reference to FIG. 38, in the case where the display panel 10 includes the support portions 8, and the first electrodes 41 of two light-emitting devices F located in the secondary display area A2 of the display panel 10 are electrically connected to the first conductive layer 21 through the same first through hole 511, two support portions 8 are located on opposite sides of the first through hole 511.

The above are only specific embodiments of the present disclosure, but the protection scope of the present disclosure is not limited thereto, and variations or substitutions that any person skilled in the art conceives of within the technical scope of the present disclosure shall fall within the protection scope of the present disclosure. Therefore, the protection scope of the present disclosure should be determined by the protection scope of the claims.

## Claims

1. A display panel comprising a main display area and a secondary display area, the main display area surrounding at least a part of the secondary display area, wherein
the display panel comprises light-emitting devices of at least one color located in the main display area and the secondary display area; an effective light-emitting area of a light-emitting device, located in the main display area, of the light-emitting devices of at least one color is greater than an effective light-emitting area of a light-emitting device, located in the secondary display area and having a same color as the light-emitting device located in the main display area, of the light-emitting devices of at least one color; and
the display panel further comprises:
a substrate;
a first conductive layer located on a side of the substrate;
a first planarization layer located on a side of the first conductive layer away from the substrate, the first planarization layer having first through holes;
a first electrode layer located on a side of the first planarization layer away from the substrate, wherein the first electrode layer comprises first electrodes of the light-emitting devices of at least one color, and a first electrode in light-emitting devices of at least one color located in the secondary display area is electrically connected to the first conductive layer through a first through hole; and
support portions located in the secondary display area, wherein the first planarization layer covers the support portions; a support portion is close to the first through hole, and is located on a side of the first through hole close to a center of the first electrode; a material of the support portion is different from a material of the first planarization layer.

2. The display panel according to claim 1, wherein the support portion is embedded in the first planarization layer; in a thickness direction of the display panel, there is a gap between the support portion and the first conductive layer, and between the support portion and the first electrode.

3. The display panel according to claim 1, wherein the support portion is in contact with the first conductive layer.

4. The display panel according to claim 3, wherein the material of the support portion is same as a material of the first conductive layer, and the support portion and the first conductive layer are in an integral structure.

5. The display panel according to any one of claims 1 to 4, wherein the material of the support portion comprises at least one of metal and metal oxide.

6. The display panel according to any one of claims 1 to 5, wherein the support portion surrounds at least a portion of the first through hole.

7. The display panel according to any one of claims 1 to 6, wherein the first through hole has a first opening located in a surface of the first planarization layer away from the substrate, and a second opening located in a surface of the first planarization layer close to the substrate; an area of the first opening is greater than an area of the second opening; and
in orthographic projections on the substrate, at least a portion of the support portion is located between boundaries of the first opening and the second opening.

8. The display panel according to any one of claims 1 to 7, further comprising a pixel definition layer located on a side of the first electrode layer away from the substrate, wherein the pixel definition layer has pixel openings;
the first through hole has a first opening located in a surface of the first planarization layer away from the substrate, and a second opening located in a surface of the first planarization layer close to the substrate; an area of the first opening is greater than an area of the second opening; and
in orthographic projections on the substrate, at least a portion of the support portion is located between boundaries of the second opening and a pixel opening.

9. The display panel according to claim 8, wherein a straight line passing through a center of the first through hole and along a preset direction is a reference line, and the preset direction is a direction in which a main body portion and a connection portion of the first electrode are connected;
a boundary of the first through hole intersects the reference line at a first intersection point and a second intersection point, and the first intersection point is farther away from the pixel opening than the second intersection point; a boundary of the pixel opening intersects the reference line at a third intersection point and a fourth intersection point, and the third intersection point is closer to the first through hole than the fourth intersection point;
a distance between the second intersection point and the third intersection point is a first length, and a distance between the third intersection point and the fourth intersection point is a second length;
the light-emitting devices of at least one color comprise first color light-emitting devices, and a second length corresponding to a first color light-emitting device is less than a second length corresponding to other color light-emitting devices; and
the support portions comprise a first support portion, and the first support portion is close to a first through hole corresponding to a first electrode of the first color light-emitting device.

10. The display panel according to claim 9, wherein the light-emitting devices of at least one color further comprise second color light-emitting devices; the support portions further comprise a second support portion, and the second support portion is close to a first through hole corresponding to a first electrode of a second color light-emitting device;
the second length corresponding to the first color light-emitting device is less than a second length corresponding to the second color light-emitting device; and
a dimension of the first support portion along an axis of the preset direction is greater than a dimension of the second support portion along the axis of the preset direction.

11. The display panel according to claim 9 or 10, wherein the first length is L1, and the second length is L2; and
L1 is greater than or equal to 7 µm; or
L1 is less than 7 µm, and L2 = n × L1 + m, where -1.5 ≥ n ≥ -3 and 30 ≥ m ≥ 20.

12. The display panel according to any one of claims 9 to 11, wherein light-emitting devices of at least one color located in the secondary display area are arranged in an array along a row direction and a column direction;
along the column direction, first through holes corresponding to first electrodes in two adjacent rows of first color light-emitting devices are located between pixel openings corresponding to the first electrodes in the two adjacent rows of first color light-emitting devices; or
along the row direction, first through holes corresponding to first electrodes in two adjacent columns of first color light-emitting devices are located between pixel openings corresponding to the first electrodes in the two adjacent columns of first color light-emitting devices.

13. The display panel according to claim 12, wherein the light-emitting devices of at least one color further comprise second color light-emitting devices;
along the column direction, first through holes corresponding to first electrodes in two adjacent rows of second color light-emitting devices are located between pixel openings corresponding to the first electrodes in the two adjacent rows of second color light-emitting devices; or
along the row direction, first through holes corresponding to first electrodes in two adjacent columns of second color light-emitting devices are located between pixel openings corresponding to the first electrodes in the two adjacent columns of second color light-emitting devices.

14. The display panel according to any one of claims 8 to 13, wherein inner diameters of the pixel opening along different axial directions are not completely equal, and the pixel opening has a maximum inner diameter value along an axis of a preset direction; the preset direction is a direction in which a main body portion and a connection portion of the first electrode are connected.

15. The display panel according to any one of claims 1 to 14, wherein at least two first electrodes located in the secondary display area are electrically connected to the first conductive layer through a same first through hole.

16. The display panel according to claim 15, wherein two first electrodes are electrically connected to the first conductive layer through the same first through hole, and the two first electrodes are located on opposite sides of the first through hole.

17. The display panel according to claim 16, wherein the support portion is arranged around the first through hole; or
there are two support portions, and the two support portions are located on opposite sides of the first through hole.

18. The display panel according to any one of claims 1 to 17, further comprising:
a second conductive layer located on a side of the first conductive layer close to the substrate;
a second planarization layer located between the second conductive layer and the first conductive layer;
first pixel circuits located in the main display area, wherein light-emitting devices of at least one color located in the main display area are electrically connected to corresponding first pixel circuits, and the light-emitting devices of at least one color located in the main display area overlap with the corresponding first pixel circuits in a thickness direction of the display panel; and
second pixel circuits located in the main display area, wherein light-emitting devices of at least one color located in the secondary display area are electrically connected to corresponding second pixel circuits at least through conductive lines of the first conductive layer and/or conductive lines of the second conductive layer; the light-emitting devices of at least one color located in the secondary display area have non-overlapping with the corresponding second pixel circuits in the thickness direction of the display panel; or
second pixel circuits located in the secondary display area, wherein the light-emitting devices of at least one color located in the secondary display area are electrically connected to corresponding second pixel circuits at least through conductive portions of the first conductive layer and/or conductive portions of the second conductive layer; the light-emitting devices of at least one color located in the secondary display area overlap with the corresponding second pixel circuits in the thickness direction of the display panel.

19. A display panel comprising a main display area and a secondary display area, the main display area surrounding at least a part of the secondary display area, wherein
the display panel comprises light-emitting devices of at least one color located in the main display area and the secondary display area; an effective light-emitting area of a light-emitting device, located in the main display area, of the light-emitting devices of at least one color is greater than an effective light-emitting area of a light-emitting device, located in the secondary display area and having a same color as the light-emitting device located in the main display area, of the light-emitting devices of at least one color; and
the display panel further comprises:
a substrate;
a first conductive layer located on a side of the substrate;
a first planarization layer located on a side of the first conductive layer away from the substrate, the first planarization layer having first through holes;
a first electrode layer located on a side of the first planarization layer away from the substrate, wherein the first electrode layer comprises first electrodes of the light-emitting devices of at least one color, and a first electrode in light-emitting devices of at least one color located in the secondary display area is electrically connected to the first conductive layer through a first through hole; and
a pixel definition layer located on a side of the first electrode layer away from the substrate, wherein the pixel definition layer has pixel openings;
wherein the first electrode comprises a main body portion and a connection portion, and the main body portion overlaps with a pixel opening in a thickness direction of the display panel; the connection portion is electrically connected to the main body portion, and the connection portion passes through the first through hole and is electrically connected to the first conductive layer;
a straight line passing through a center of the first through hole and along a preset direction is a reference line, and the preset direction is a direction in which the main body portion and the connection portion of the first electrode are connected;
a boundary of the first through hole intersects the reference line at a first intersection point and a second intersection point, and the first intersection point is farther away from the pixel opening than the second intersection point; a boundary of the pixel opening intersects the reference line at a third intersection point and a fourth intersection point, and the third intersection point is closer to the first through hole than the fourth intersection point;
a distance between the second intersection point and the third intersection point is a first length, and a distance between the third intersection point and the fourth intersection point is a second length;
the first length is L1, and the second length is L2; L1 is greater than or equal to 7 µm; or
L1 is less than 7 µm, and L2 = n × L1 + m, where -1.5 ≥ n ≥ -3 and 30 ≥ m ≥ 20.

20. A display panel comprising a main display area and a secondary display area, the main display area surrounding at least a part of the secondary display area, wherein
the display panel comprises light-emitting devices of at least one color located in the main display area and the secondary display area; an effective light-emitting area of a light-emitting device, located in the main display area, of the light-emitting devices of at least one color is greater than an effective light-emitting area of a light-emitting device, located in the secondary display area and having a same color as the light-emitting device located in the main display area, of the light-emitting devices of at least one color; and
the display panel further comprises:
a substrate;
a first conductive layer located on a side of the substrate;
a first planarization layer located on a side of the first conductive layer away from the substrate, the first planarization layer having first through holes;
a first electrode layer located on a side of the first planarization layer away from the substrate, wherein the first electrode layer comprises first electrodes of the light-emitting devices of at least one color, and a first electrode in light-emitting devices of at least one color located in the secondary display area is electrically connected to the first conductive layer through a first through hole; the first electrode comprises a main body portion and a connection portion electrically connected to the main body portion, and the connection portion passes through the first through hole and is electrically connected to the first conductive layer; and
a pixel definition layer located on a side of the first electrode layer away from the substrate, wherein the pixel definition layer has pixel openings; the main body portion overlaps with a pixel opening in a thickness direction of the display panel; inner diameters of the pixel opening along different axial directions are not completely equal, and the pixel opening has a maximum inner diameter value along an axis of a preset direction; the preset direction is a direction in which the main body portion and the connection portion of the first electrode are connected.

21. A display panel comprising a main display area and a secondary display area, the main display area surrounding at least a part of the secondary display area, wherein
the display panel comprises light-emitting devices of at least one color located in the main display area and the secondary display area; an effective light-emitting area of a light-emitting device, located in the main display area, of the light-emitting devices of at least one color is greater than an effective light-emitting area of a light-emitting device, located in the secondary display area and having a same color as the light-emitting device located in the main display area, of the light-emitting devices of at least one color; and
the display panel further comprises:
a substrate;
a first conductive layer located on a side of the substrate;
a first planarization layer located on a side of the first conductive layer away from the substrate, the first planarization layer having first through holes; and
a first electrode layer located on a side of the first planarization layer away from the substrate, wherein the first electrode layer comprises first electrodes of the light-emitting devices of at least one color; first electrodes of at least two light-emitting devices of at least one color located in the secondary display area are electrically connected to the first conductive layer through a same first through hole.

22. A display panel comprising a main display area and a secondary display area, the main display area surrounding at least a part of the secondary display area, wherein
the display panel comprises light-emitting devices of at least one color located in the main display area and the secondary display area; an effective light-emitting area of a light-emitting device, located in the main display area, of the light-emitting devices of at least one color is greater than an effective light-emitting area of a light-emitting device, located in the secondary display area and having a same color as the light-emitting device located in the main display area, of the light-emitting devices of at least one color; and
the display panel further comprises:
a substrate;
a first conductive layer located on a side of the substrate;
a first planarization layer located on a side of the first conductive layer away from the substrate, the first planarization layer having first through holes;
a first electrode layer located on a side of the first planarization layer away from the substrate, wherein the first electrode layer comprises first electrodes of the light-emitting devices of at least one color, and a first electrode in light-emitting devices of at least one color located in the secondary display area is electrically connected to the first conductive layer through a first through hole; and
a pixel definition layer located on a side of the first electrode layer away from the substrate, wherein the pixel definition layer has pixel openings, and the first electrode overlaps with a pixel opening in a thickness direction of the display panel, wherein
light-emitting devices of at least one color located in the secondary display area are arranged in an array along a row direction and a column direction; the light-emitting devices of at least one color comprise first color light-emitting devices;
along the column direction, first through holes corresponding to first electrodes in two adjacent rows of first color light-emitting devices are located between pixel openings corresponding to the first electrodes in the two adjacent rows of first color light-emitting devices; or
along the row direction, first through holes corresponding to first electrodes in two adjacent columns of first color light-emitting devices are located between pixel openings corresponding to the first electrodes in the two adjacent columns of first color light-emitting devices.

23. A manufacturing method for a display panel, the display panel comprising a main display area and a secondary display area, the main display area surrounding at least a part of the secondary display area, wherein
the display panel comprises light-emitting devices of at least one color located in the main display area and the secondary display area; an effective light-emitting area of a light-emitting device, located in the main display area, of the light-emitting devices of at least one color is greater than an effective light-emitting area of a light-emitting device, located in the secondary display area and having a same color as the light-emitting device located in the main display area, of the light-emitting devices of at least one color; and
the manufacturing method for the display panel comprises:
forming a first conductive layer on a side of a substrate;
forming a first planarization layer on a side of the first conductive layer away from the substrate, wherein within regions of the first planarization layer where first through holes are to be formed, a surface of the first planarization layer away from the substrate protrudes towards a side of the first planarization layer away from the substrate;
forming the first through holes in the first planarization layer; and
forming a first electrode layer on the side of the first planarization layer away from the substrate, wherein the first electrode layer comprises first electrodes of the light-emitting devices of at least one color, and a first electrode in light-emitting devices of at least one color located in the secondary display area is electrically connected to the first conductive layer through a first through hole.

24. A display apparatus, comprising:
the display panel according to any one of claims 1 to 22; and
an optical device located on a non-display surface of the display panel and overlapping with the secondary display area of the display panel in a thickness direction of the display panel.
